(19) Europäisches Patentamt
European Patent Office
Office européen des brevets

(11) EP 4 692 944 A1

# (12) EUROPEAN PATENT APPLICATION

published in accordance with Art. 153(4) EPC

(43) Date of publication:
**11.02.2026 Bulletin 2026/07**

(21) Application number: **24780859.5**

(22) Date of filing: **29.03.2024**

(51) International Patent Classification (IPC):
***G03F 7/11*** *(2006.01)* ***C08G 8/04*** *(2006.01)*

(52) Cooperative Patent Classification (CPC):
**C08G 8/04; G03F 7/11**

(86) International application number:
**PCT/JP2024/013182**

(87) International publication number:
**WO 2024/204764 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 JP 2023057706**

(71) Applicant: **Nissan Chemical Corporation**
**Tokyo 103-6119 (JP)**

(72) Inventors:
- **OGATA, Hiroto**
  **Toyama-shi, Toyama 939-2792 (JP)**
- **ITAOKA, Kohei**
  **Toyama-shi, Toyama 939-2792 (JP)**
- **MATSUO, Mina**
  **Funabashi-shi, Chiba 274-8507 (JP)**
- **TAMURA, Mamoru**
  **Toyama-shi, Toyama 939-2792 (JP)**

(74) Representative: **Hoffmann Eitle**
**Patent- und Rechtsanwälte PartmbB**
**Arabellastraße 30**
**81925 München (DE)**

## (54) COMPOSITION FOR FORMING RESIST UNDERLAYER FILM

(57) A resist underlayer film-forming composition, containing a compound (A) containing an aromatic hydrocarbon ring to which a phenolic hydroxy group is bonded and a solvent (B), in which an atomic percentage of oxygen in the phenolic hydroxy group in a cured film of the composition is 2.00% or more.

EP 4 692 944 A1

## Description

### Technical Field

The present invention relates to a resist underlayer film-forming composition, a resist underlayer film, a laminate, a method for producing a semiconductor element, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, semiconductor devices have become more highly integrated, and also as the active ray to be used, in addition to an i-line (wavelength: 365 nm), a KrF excimer laser (wavelength: 248 nm), and an ArF excimer laser (wavelength: 193 nm) that have been conventionally used, practical application of EUV light (wavelength: 13.5 nm) or an electron beam (EB) has been studied for the most advanced microfabrication. Along with this, poor resist pattern formation due to an influence of a semiconductor substrate or the like has become a major problem. Therefore, in order to solve this problem, a method of providing a resist underlayer film between a resist and a semiconductor substrate has been widely studied.

Patent Literature 1 discloses an underlayer film-forming composition for lithography containing a naphthalene ring having a halogen atom. Patent Literature 2 discloses a halogenated antireflection film. Patent Literature 3 discloses a resist underlayer film-forming composition.

### Citation List

### Patent Literature

Patent Literature 1: WO 2006/003850 A
Patent Literature 2: JP 2005-526270 A
Patent Literature 3: WO 2020/111068 A

### Summary of Invention

### Technical Problem

Examples of the characteristics required for a resist underlayer film include no intermixing with a resist film formed on an upper layer (insolubility in a resist solvent), and a capability of forming a resist pattern with high sensitivity.

The present invention has been made in view of the above circumstances, and an object of the present invention is to provide a resist underlayer film-forming composition capable of forming a resist underlayer film on which a resist pattern can be formed with high sensitivity, and a resist underlayer film, a laminate, a method for producing a semiconductor element, and a pattern forming method, for all of which the resist underlayer film-forming composition is used.

### Solution to Problem

As a result of intensive studies to solve the above problem, the present inventors have found that the above problem can be solved and completed the present invention having the following gist.

That is, the present invention includes the following aspects.

[1] A resist underlayer film-forming composition, containing a compound (A) containing an aromatic hydrocarbon ring to which a phenolic hydroxy group is bonded; and a solvent (B),
wherein an atomic percentage of oxygen in the phenolic hydroxy group in a cured film of the composition is 2.00% or more.

[2] The resist underlayer film-forming composition according to [1], wherein the compound (A) contains at least any of

a phenolic resin, a naphthol resin, a biphenol resin, polyhydroxystyrenes, and polyhydroxyvinylnaphthalenes.

[3] The resist underlayer film-forming composition according to [1], wherein the compound (A) is a low molecular compound (A-1) containing two or more phenolic hydroxy groups and having a molecular weight of 5,000 or less.

[4] The resist underlayer film-forming composition according to any one of [1] to [3], further containing: a crosslinking agent (C).

[5] The resist underlayer film-forming composition according to any one of [1] to [4] that is a resist underlayer film-forming composition for EUV or electron beam lithography.

[6] A resist underlayer film that is a cured product of the resist underlayer film-forming composition according to any one of [1] to [5].

[7] The resist underlayer film according to [6], wherein the atomic percentage of oxygen in the phenolic hydroxy group is 2.00% or more in the resist underlayer film.

[8] The resist underlayer film according to [6] or [7], wherein a film thickness is 2 nm or more and 20 nm or less.

[9] A laminate, including:

a semiconductor substrate; and
the resist underlayer film according to any one of [6] to [8].

[10] A method for producing a semiconductor element, the method including the steps of:

forming a resist underlayer film on a semiconductor substrate using the resist underlayer film-forming composition according to any one of [1] to [5]; and
forming a resist film on the resist underlayer film.

[11] A pattern forming method, including the steps of:

forming a resist underlayer film on a semiconductor substrate using the resist underlayer film-forming composition according to any one of [1] to [5];
forming a resist film on the resist underlayer film;
irradiating the resist film with light or an electron beam, and then developing the resist film to obtain a resist pattern; and
etching the resist underlayer film using the resist pattern as a mask.

## Advantageous Effects of Invention

According to the present invention, it is possible to provide a resist underlayer film-forming composition capable of forming a resist underlayer film on which a resist pattern can be formed with high sensitivity, and a resist underlayer film, a laminate, a method for producing a semiconductor element, and a pattern forming method, for all of which the resist underlayer film-forming composition is used.

## Description of Embodiments

### (Resist underlayer film-forming composition)

A resist underlayer film-forming composition of the present invention contains a compound (A) containing an aromatic hydrocarbon ring to which a phenolic hydroxy group is bonded and a solvent (B).

The resist underlayer film-forming composition may contain a crosslinking agent (C), a curing catalyst (D), and the like.

The atomic percentage of oxygen in the phenolic hydroxy group in a cured film of the composition is 2.00% or more, preferably 2.00% or more and 30.00% or less, and more preferably 3.00% or more and 20.00% or less. When the atomic percentage of oxygen in the phenolic hydroxy group in the cured film of the composition is 2.00% or more, it becomes possible to form a resist underlayer film capable of forming a resist pattern with high sensitivity.

The atomic percentage of oxygen in the phenolic hydroxy group in the cured film of the composition can be obtained by, for example, the following method.

The resist underlayer film-forming composition is applied onto a silicon wafer using a spinner. The silicon wafer is baked at 205°C for 60 seconds on a hot plate to obtain a resist underlayer film having a film thickness of 5 nm. The silicon wafer on which the resist underlayer film has been formed is cut into a size of about 0.5 × 1 cm and dried in a vacuum for 20 hours or longer. After that, the silicon wafer is sealed in a 6.0 × 7.5 cm weighing bottle together with 3 ml of trifluoroacetic

anhydride, and a hydrogen atom in the phenolic hydroxy group is substituted with a trifluoroacetyl group by a gas phase chemical modification method at a temperature of 25°C. Regarding the reaction time, a time required to reach the reaction equilibrium is confirmed, and the reaction time is set thereto for each composition. Furthermore, unreacted trifluoroacetic anhydride and trifluoroacetic acid generated as a by-product are removed by 20 hours or longer of vacuum drying. After that, the number of each atom constituting the film is measured using X-ray photoelectron spectroscopy (Quanterar SXM) in which an AlKa ray is used as a radiation source (excluding hydrogen). In addition, the atomic percentage ($R_{OH}$ [atom%]) of oxygen in the phenolic hydroxy group in the resist underlayer film is obtained using the following formula.

[Math. 1]

$$R_{\mathrm{OH}}[atom\%] = \frac{F}{A} \times \frac{1}{3} \times 100$$

F: Number of fluorine atoms
A: Total number of atoms (hydrogen atoms are excluded)

In a case where the resist underlayer film before the gas-phase chemical modification method has a fluorine atom, the fluorine atom is not included in F in the mathematical formula.
The atomic percentage of oxygen in the phenolic hydroxy group in the cured film of the composition can be adjusted by appropriately selecting the amount of the compound (A) in the resist underlayer film-forming composition and the type of the compound (A).

<Compound (A)>

The compound (A) contains an aromatic hydrocarbon ring to which a phenolic hydroxy group is bonded.
The compound (A) may be a low molecular compound or a high-molecular-weight compound.
Examples of the aromatic hydrocarbon ring include a benzene ring, a naphthalene ring, an anthracene ring, a pyrene ring, and the like.
That is, "phenolic hydroxy group" has the same meaning as a hydroxy group directly bonded to an aromatic hydrocarbon ring.
The number of phenolic hydroxy groups bonded to one aromatic hydrocarbon ring is not particularly limited, and may be one or more.
The number of aromatic hydrocarbon rings to which the phenolic hydroxy group is bonded in the compound (A) is not particularly limited, and may be one or more.
From the viewpoint of suitably obtaining the effect of the present invention, the compound (A) is preferably a phenolic resin, a naphthol resin, a biphenol resin, polyhydroxystyrenes, polyhydroxyvinylnaphthalenes, or a low molecular compound (A-1) containing four or more phenolic hydroxy groups and having a molecular weight of 5,000 or less.
The molecular weight of the compound (A) is not particularly limited; however, for example, the weight average molecular weight is preferably 100,000 or less, and more preferably 70,000 or less.
The weight average molecular weight can be obtained by, for example, gel permeation chromatography (GPC).

<<Phenolic resin, naphthol resin, and biphenol resin>>

The phenolic resin, the naphthol resin, and the biphenol resin (hereinafter these will be referred to as "phenolic resins" in some cases) are, for example, resins obtained by condensation reaction of a phenolic compound and at least any of an aldehyde compound, a ketone compound, and a divinyl compound under an acid catalyst.
Examples of the phenolic compound include phenols, naphthols, anthrols, hydroxypyrenes, and the like.
Examples of the phenols include phenol, cresol, xylenol, resorcinol, biphenol, bisphenol F, bisphenol A, p-tert-butylphenol, p-octylphenol, 9,9-bis(4-hydroxyphenyl)fluorene, 1,1,2,2-tetrakis(4-hydroxyphenyl)ethane, and the like.
Examples of the naphthols include 1-naphthol, 2-naphthol, 1,5-dihydroxynaphthalene, 2,7-dihydroxynaphthalene, 9,9-bis(6-hydroxynaphthyl)fluorene, and the like.
Examples of the anthrols include 9-anthrol and the like.
Examples of the hydroxypyrenes include 1-hydroxypyrene, 2-hydroxypyrene, and the like.
One type of these phenolic compounds can be used singly or two or more types thereof can be used in combination.

These may have a substituent. For example, these may have a substituent in an aromatic ring.

Examples of the aldehyde compound include saturated aliphatic aldehydes, unsaturated aliphatic aldehydes, heterocyclic aldehydes, aromatic aldehydes, and the like. Examples of the saturated aliphatic aldehydes include formaldehyde, paraformaldehyde, acetaldehyde, propylaldehyde, butyraldehyde, isobutyraldehyde, valeraldehyde, capronaldehyde, 2-methylbutyraldehyde, hexylaldehyde, undecanaldehyde, 7-methoxy-3,7-dimethyloctylaldehyde, cyclohexanaldehyde, 3-methyl-2-butyraldehyde, 2-ethylhexylaldehyde, glyoxal, malonaldehyde, succinaldehyde, glutaraldehyde, adipine aldehyde, and the like. Examples of the unsaturated aliphatic aldehydes include acrolein, methacrolein, and the like. Examples of the heterocyclic aldehydes include furfural, pyridine aldehyde, and the like. Examples of the aromatic aldehydes include benzaldehyde, naphthylaldehyde, anthrylaldehyde, phenanthrylaldehyde, salicylaldehyde, phenylacetaldehyde, 3-phenylpropionaldehyde, tolylaldehyde, (N,N-dimethylamino)benzaldehyde, acetoxybenzaldehyde, and the like. Among them, saturated aliphatic aldehydes and aromatic aldehydes are preferable.

Examples of the ketone compound include diaryl ketone compounds. Examples of the diaryl ketone compounds include diphenyl ketone, phenyl naphthyl ketone, dinaphthyl ketone, phenyl tolyl ketone, ditolyl ketone, and the like.

Examples of the divinyl compound include divinylbenzene, dicyclopentadiene, tetrahydroindene, 4-vinylcyclohexene, 5-vinylnoborna-2-ene, divinylpyrene, limonene, 5-vinylnorbornadiene, and the like.

One type of these phenolic resins can be used singly or two or more types thereof can be used in combination.

The phenolic resins preferably include a structural unit represented by Formula (1) below:

[Chem. 1]

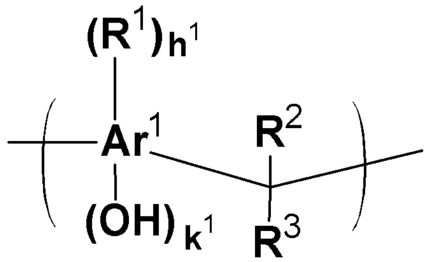

(1)

In Formula (1), $R^1$'s represent a substituent substituted with a ring, and each independently represent a halogen atom, a nitro group, a cyano group, an amino group, an optionally substituted alkyl group, an optionally substituted alkenyl group, or an optionally substituted aryl group.

$R^2$ represents a hydrogen atom, an optionally substituted aryl group, or an optionally substituted heteroaryl group.

$R^3$ represents a hydrogen atom, an optionally substituted alkyl group, an optionally substituted aryl group, or an optionally substituted heteroaryl group.

The group of $R^2$ and the group of $R^3$ may be bonded to each other to form a divalent group.

Examples of the substituent of the aryl group and the heteroaryl group include a halogen atom, a nitro group, a cyano group, an amino group, a hydroxy group, a carboxy group, an alkyl group, an alkenyl group, and the like.

$Ar^1$ represents a benzene ring, a naphthalene ring, or a biphenyl structure.

$h^1$ each independently represents an integer of 0 to 4.

$k^1$ each independently represents an integer of 1 to 4.

When $Ar^1$ is a benzene ring, the total of $h^1$ and $k^1$ is 4 or less, when $Ar^1$ is a naphthalene ring, the total of $h^1$ and $k^1$ is 6 or less, and when $Ar^1$ has a biphenyl structure, the total of $h^1$ and $k^1$ is 8 or less.

Hereinafter, specific examples of the structural unit represented by Formula (1) will be given, but the structural unit is not limited thereto.

[Chem. 2]

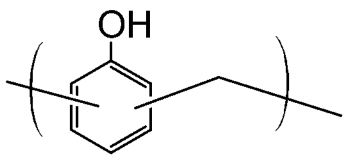

(1-1)

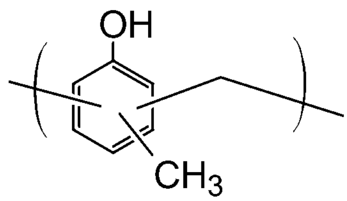

(1-2)

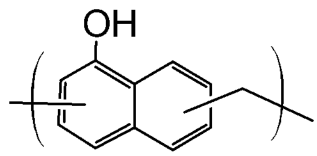

(1-3)

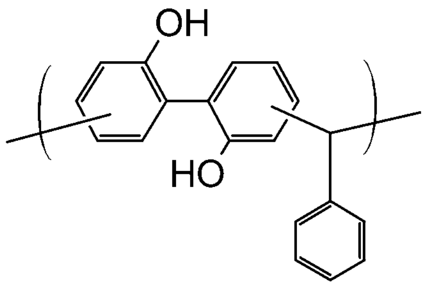

(1-4)

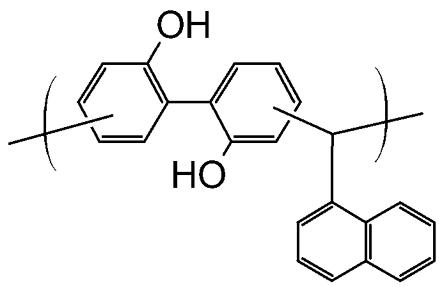

(1-5)

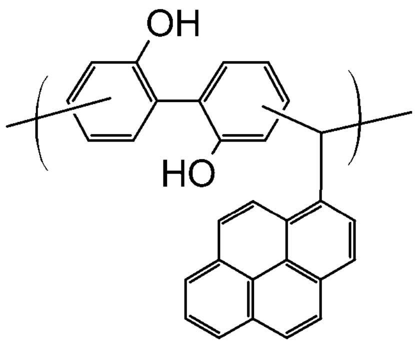

(1-6)

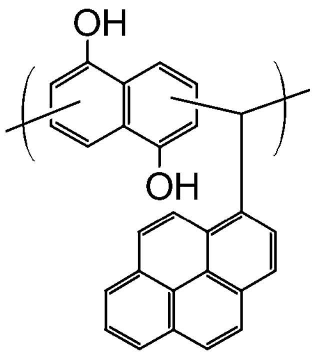

(1-7)

[Chem. 3]

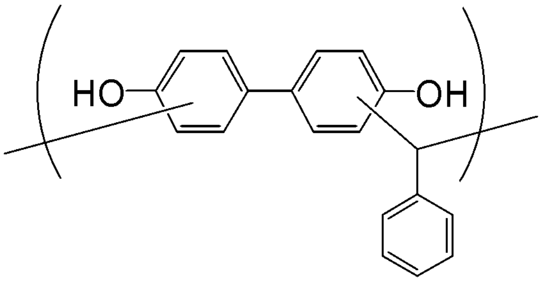

(1-8)

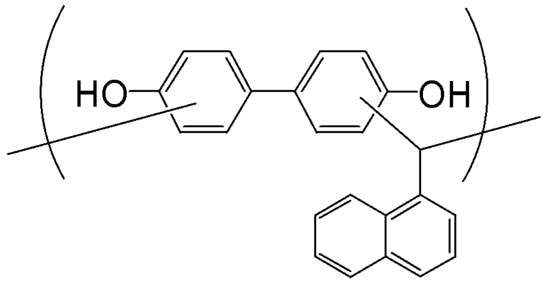

(1-9)

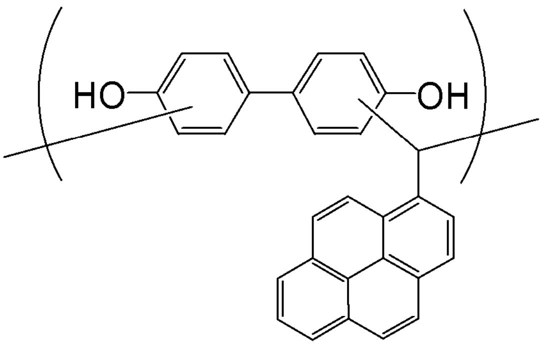

(1-10)

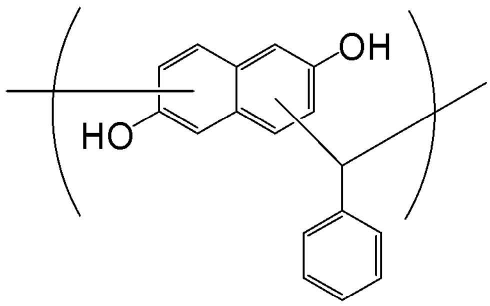

(1-11)

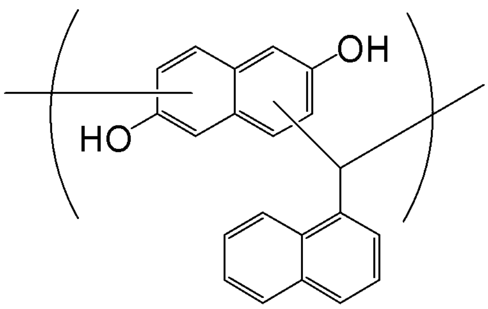

(1-12)

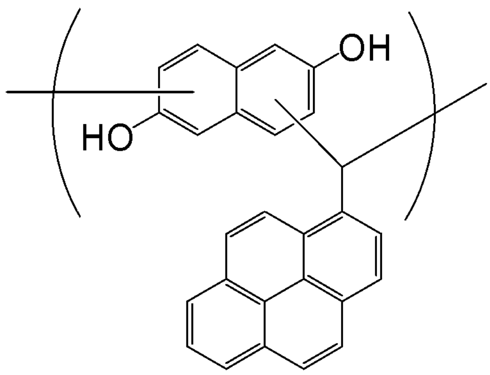

(1-13)

Hereinafter, specific examples of the phenols will be described, but the phenols are not limited thereto.

[Chem. 4]

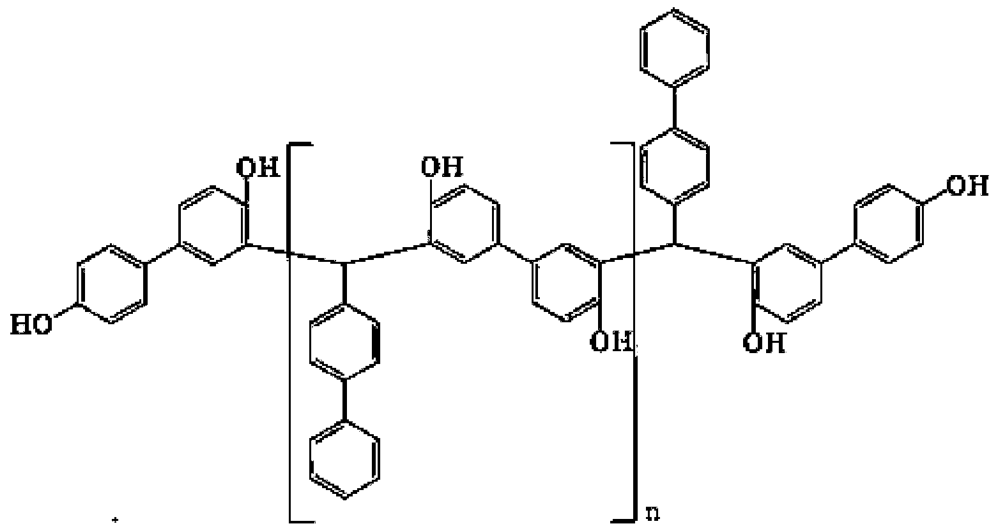

(1-14)

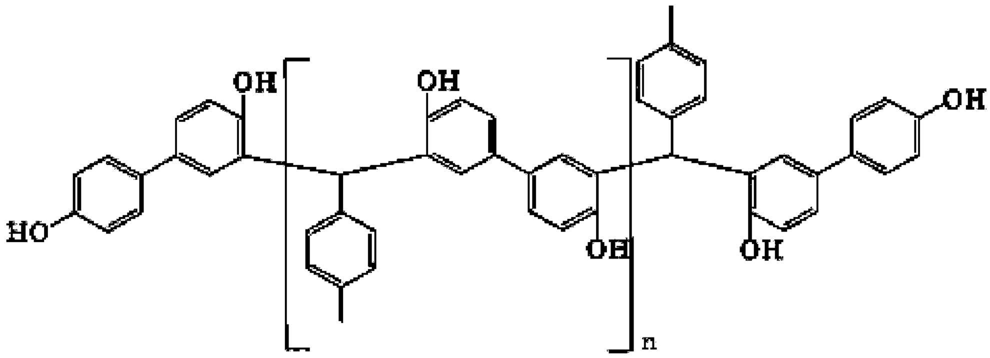

(1-15)

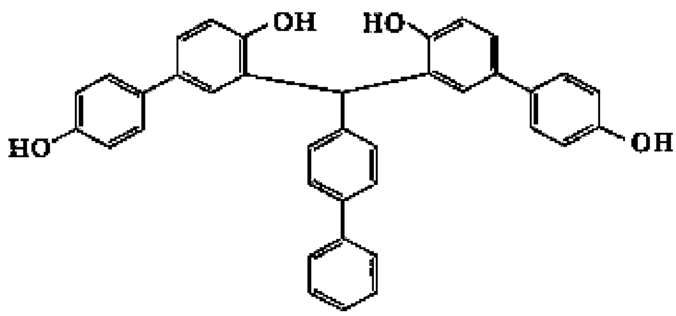

(1-16)

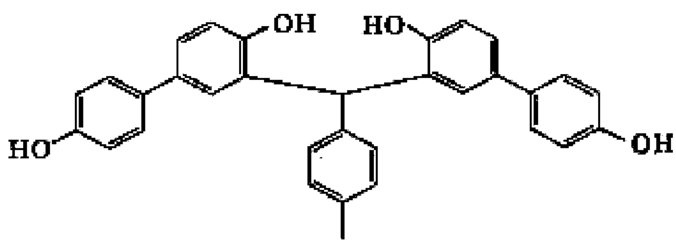

(1-17)

n represents an integer of 0 to 4.

Examples of the phenols include NeoFARIT 7177C (manufactured by MITSUBISHI GAS CHEMICAL COMPANY, INC.), NeoFARIT V002-EA2 (manufactured by MITSUBISHI GAS CHEMICAL COMPANY, INC.), NeoFARIT V003 (manufactured by MITSUBISHI GAS CHEMICAL COMPANY, INC.), and the like.

As described above, the phenols are, for example, resins obtained by condensation reaction of a phenolic compound and at least any of an aldehyde compound, a ketone compound, and a divinyl compound under an acid catalyst.

In this condensation reaction, for example, the aldehyde compound or the ketone compound is usually used in a ratio of 0.1 to 10 equivalents to 1 equivalent of a benzene ring constituting a ring of the phenolic compound.

In the condensation reaction, an acid catalyst is usually used.

Examples of the acid catalyst include mineral acids such as sulfuric acid, phosphoric acid, and perchloric acid, organic sulfonic acids such as p-toluenesulfonic acid and p-toluenesulfonic acid monohydrate, and carboxylic acids such as formic acid and oxalic acid, but are not limited thereto.

The amount of the acid catalyst is appropriately determined depending on the type of the acid to be used and the like, and thus cannot be generally defined, but is usually appropriately determined from the range of 0.001 to 10,000 parts by mass with respect to 100 parts by mass of the phenolic compound.

When either the raw material compound or the acid catalyst to be used is a liquid, the condensation reaction can be performed without using a solvent in some cases, but is usually performed using a solvent.

Such a solvent is not particularly limited as long as the reaction is not inhibited, but typical examples thereof include an ether compound, an ether ester compound, and the like.

Examples of the ether compound include cyclic ether compounds such as tetrahydrofuran and dioxane.

Examples of the ether ester compound include methyl cellosolve acetate, ethyl cellosolve acetate, butyl cellosolve acetate, propylene glycol monomethyl ether acetate (PGMEA), propylene glycol monoethyl ether acetate, propylene glycol monopropyl ether acetate, propylene glycol monomethyl ether propionate, propylene glycol monoethyl ether propionate, propylene glycol monopropyl ether propionate, and the like.

The reaction temperature is usually appropriately determined from the range of 40°C to 200°C, and the reaction time cannot be generally specified because the reaction time varies depending on the reaction temperature, but is usually appropriately determined from the range of 30 minutes to 50 hours.

After completion of the reaction, if necessary, purification and isolation are performed according to a conventional method, and the obtained phenols are used for preparation of the resist underlayer film-forming composition.

Those skilled in the art can determine the production conditions of the phenols without an excessive burden based on the above description and the common general technical knowledge, and therefore can produce the phenols.

<<Polyhydroxystyrenes>>

Examples of the polyhydroxystyrenes include polyhydroxystyrene and polyhydroxystyrene derivatives.

Examples of the polyhydroxystyrene or polyhydroxystyrene derivatives include poly-o-hydroxystyrene, poly-m-hydroxystyrene, poly-p-hydroxystyrene, poly-α-methyl-o-hydroxystyrene, poly-α-methyl-m-hydroxystyrene, poly-α-methyl-p-hydroxystyrene, and the like.

The polyhydroxystyrene or polyhydroxystyrene derivatives may be a hydroxystyrene homopolymer optionally having a substituent or a copolymer optionally having a substituent obtained by copolymerization of hydroxystyrene and a different compound. Examples of the different compound at this time include (meth)acrylic acid, (meth)acrylic acid derivatives described below, acrylonitrile, methacrylonitrile, styrene derivatives such as styrene, α-methylstyrene, p-methylstyrene, o-methylstyrene, p-methoxystyrene, and p-chlorostyrene, and the like.

The polyhydroxystyrenes are obtained by polymerizing hydroxystyrene optionally having a substituent, and preferably have, for example, a structural unit represented by Formula (2) below.

[Chem. 5]

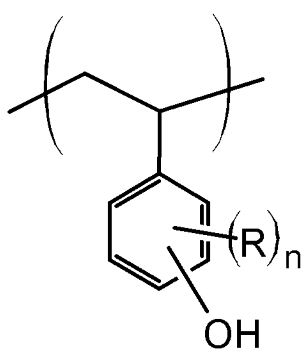

(2)

(In Formula (2), R represents a halogen atom, a carboxy group, a nitro group, a cyano group, a methylenedioxy group, an acetoxy group, a methylthio group, an amino group, or an alkoxy group having 1 to 9 carbon atoms. n represents an integer of 0 to 4. When n is 2 or more, n R's may be the same as or different from each other.)

In the present specification, examples of the halogen atom include a fluorine atom, a chlorine atom, a bromine atom, and an iodine atom.

In the present specification, examples of the alkoxy group having 1 to 9 carbon atoms include a methoxy group, an ethoxy group, an n-propoxy group, an i-propoxy group, an n-butoxy group, an i-butoxy group, an s-butoxy group, a t-butoxy group, an n-pentoxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, a 1-ethyl-2-methyl-n-propoxy group, an n-heptyloxy group, an n-octyloxy group, and an n-nonyloxy group.

Examples of the (meth)acrylic acid derivative as the copolymerization component include (meth)acrylic acid alkyl esters such as (meth)acrylic acid methyl ester, (meth)acrylic acid ethyl ester, (meth)acrylic acid propyl ester, (meth)acrylic acid butyl ester, (meth)acrylic acid pentyl ester, (meth)acrylic acid hexyl ester, (meth)acrylic acid heptyl ester, (meth)acrylic acid octyl ester, (meth)acrylic acid 2-ethylhexyl ester, (meth)acrylic acid nonyl ester, (meth)acrylic acid decyl ester, (meth) acrylic acid undecyl ester, (meth)acrylic acid dodecyl ester, (meth)acrylic acid trifluoroethyl ester, and (meth)acrylic acid tetrafluoropropyl ester; acrylamides such as diacetone acrylamide; (meth)acrylic acid tetrahydrofurfuryl ester, (meth) acrylic acid dialkylaminoethyl ester, (meth)acrylic acid glycidyl ester, and the like.

<<Polyhydroxyvinylnaphthalenes>>

Examples of the polyhydroxyvinylnaphthalenes include polyhydroxyvinylnaphthalene and polyhydroxyvinylnaphthalene derivatives.

The polyhydroxyvinylnaphthalene or the polyhydroxyvinylnaphthalene derivatives may be a hydroxyvinylnaphthalene homopolymer optionally having a substituent or a copolymer optionally having a substituent obtained by copolymerization of hydroxyvinylnaphthalene and a different compound. Examples of the different compound at this time include (meth)acrylic acid, the above-described (meth)acrylic acid derivatives, acrylonitrile, methacrylonitrile, styrene derivatives such as styrene, $\alpha$-methylstyrene, p-methylstyrene, o-methylstyrene, p-methoxystyrene, and p-chlorostyrene, and the like.

The polyhydroxyvinylnaphthalenes are obtained by polymerizing hydroxyvinylnaphthalene optionally having a substituent, and preferably have, for example, a structural unit represented by Formula (3) below.

[Chem. 6]

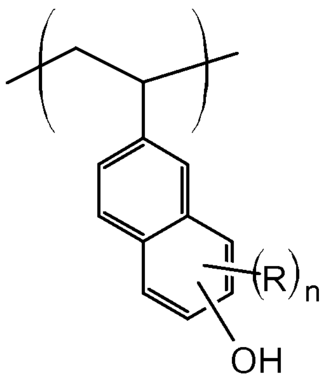

(3)

(In Formula (3), R represents a halogen atom, a carboxy group, a nitro group, a cyano group, a methylenedioxy group, an acetoxy group, a methylthio group, an amino group, or an alkoxy group having 1 to 9 carbon atoms. n represents an integer of 0 to 6. When n is 2 or more, n R's may be the same as or different from each other.)

<<Low molecular compound (A-1)>>

The low molecular compound (A-1) is not particularly limited as long as the low molecular compound is a compound containing two or more phenolic hydroxy groups and having a molecular weight of 5,000 or less.

The number of the phenolic hydroxy groups in the low molecular compound (A-1) is two or more, preferably three

to 50, and more preferably four to 30.

The molecular weight of the low molecular compound (A-1) is 5,000 or less, preferably 200 to 4,000, and more preferably 300 to 3,000.

From the viewpoint of suitably obtaining the effect of the present invention, the low molecular compound (A-1) is preferably a compound represented by Formula (A-1-1) below, a compound represented by Formula (A-1-2) below, a compound represented by Formula (A-1-3) below, or a compound represented by Formula (A-1-4) below.

<<<Compound represented by Formula (A-1-1)>>>

[Chem. 7]

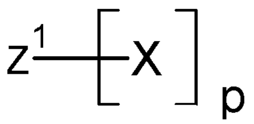

(A-1-1)

(In Formula (A-1-1), $Z^1$ represents a p-valent group.

p represents an integer of 2 to 4.

X's each independently represent an organic group represented by Formula (X) below.

[Chem. 8]

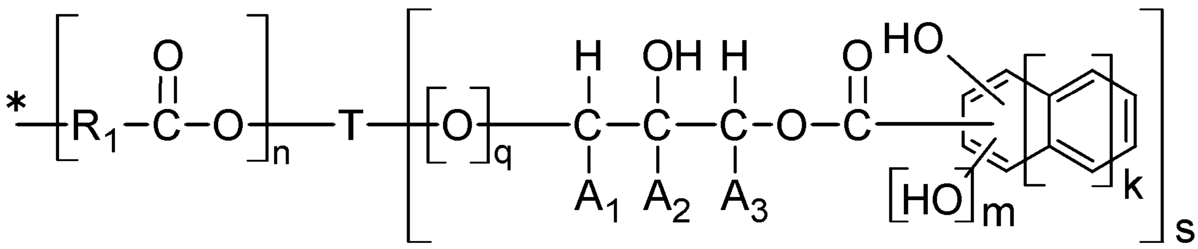

(X)

(In Formula (X), $R_1$ represents an alkylene group having 1 to 4 carbon atoms.

T represents a single bond or an (s + 1)-valent hydrocarbon group having 1 to 8 carbon atoms.

$A_1$ to $A_3$ each independently represent a hydrogen atom, a methyl group, or an ethyl group.

k represents 0 or 1.

m represents an integer of 0 to 4.

n represents 0 or 1.

q represents 0 or 1.

s represents 1 or 2.

* represents a binding moiety to $Z^1$ in Formula (A-1-1).

Here, when T is a single bond, n and q are not 1 at the same time.)

$Z^1$ in Formula (A-1-1) is not particularly limited as long as $Z^1$ is a p-valent group, but is preferably represented by Formula (Z-1) below.

[Chem. 9]

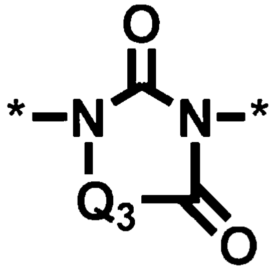

(Z-1)

(In Formula (Z-1), $Q_3$ represents Formula (Z-1-1), Formula (Z-1-2), Formula (Z-1-3), or Formula (Z-1-4) below. *'s each represent a binding moiety to X in Formula (A-1-1).)

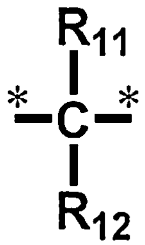

(Z-1-1)

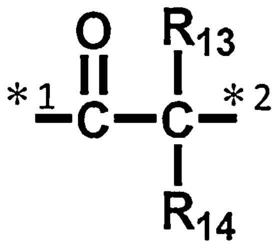

(Z-1-2)

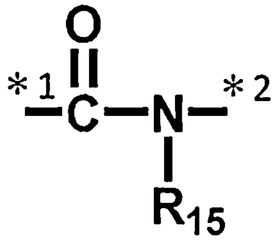

(Z-1-3)

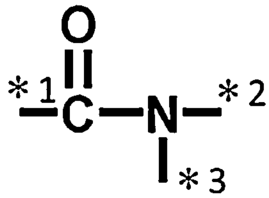

(Z-1-4)

(In Formula (Z-1-1), Formula (Z-1-2), Formula (Z-1-3), or Formula (Z-1-4), $R_{11}$ to $R_{15}$ each independently represent a hydrogen atom, an alkyl group having 1 to 10 carbon atoms, which may be interrupted by an oxygen atom or a sulfur atom, an alkenyl group having 2 to 10 carbon atoms, which may be interrupted by an oxygen atom or a sulfur atom, an alkynyl group having 2 to 10 carbon atoms, which may be interrupted by an oxygen atom or a sulfur atom, a benzyl group, or a phenyl group, where the phenyl group may be substituted with at least one monovalent functional group selected from the group consisting of an alkyl group having 1 to 6 carbon atoms, a halogen atom, an alkoxy group having 1 to 10 carbon atoms, a nitro group, a cyano group, and an alkylthio group having 1 to 6 carbon atoms. * represents a binding site. *1 represents a binding site bonded to a nitrogen atom in Formula (Z-1). *2 represents a binding site bonded to a carbon atom in Formula (Z-1). *3 represents a binding moiety to X in Formula (A-1-1).)

In Formula (Z-1), when $Q_3$ represents Formula (Z-1-1), $R_{11}$ and $R_{12}$ in Formula (Z-1-1) are each independently an alkyl group having 1 to 10 carbon atoms.

In Formula (Z-1), when $Q_3$ represents Formula (Z-1-2), $R_{13}$ and $R_{14}$ in Formula (Z-1-2) are each independently an alkyl group having 1 to 10 carbon atoms.

$Q_3$ in Formula (Z-1) is preferably Formula (Z-1-3) or Formula (Z-1-4).

$R_{15}$ in Formula (Z-1-3) is preferably an alkyl group having 1 to 10 carbon atoms which may be interrupted by an oxygen atom or a sulfur atom, or an alkenyl group having 2 to 10 carbon atoms which may be interrupted by an oxygen atom or a sulfur atom, and is more preferably an alkyl group having 1 to 10 carbon atoms or an alkenyl group having 2 to 10 carbon atoms.

The compound represented by the formula (A-1-1) can be obtained by, for example, reacting compounds represented by Formulae (a) to (w) and (ac) to (aj) below and a compound represented by Formula (Y) below by a known method, but the method is not limited thereto.

[Chem. 10]

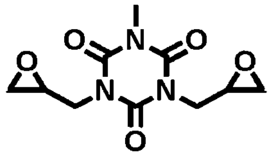

(a)

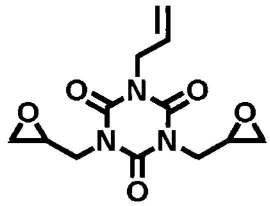

(b)

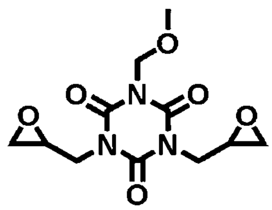

(c)

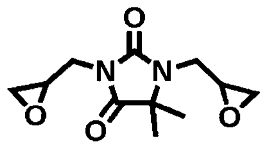

(d)

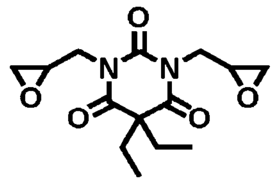

(e)

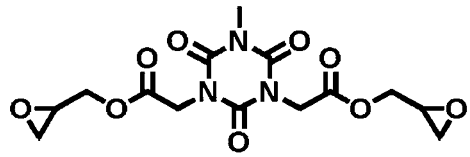

(f)

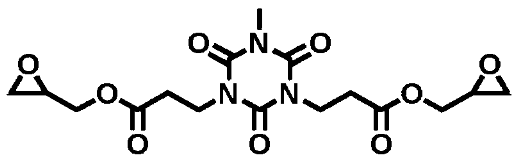

(g)

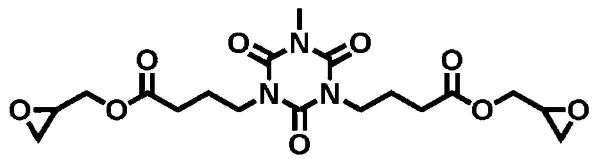

(h)

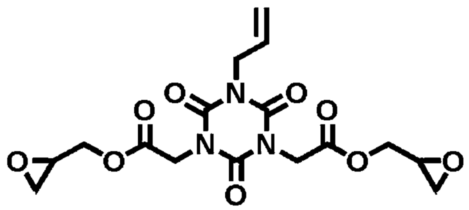

(i)

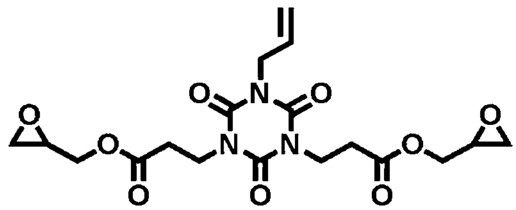

(j)

[Chem. 11]

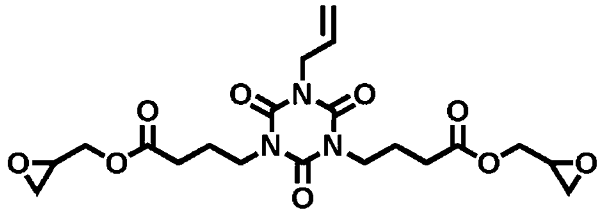

(k)

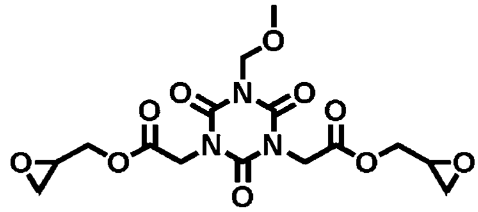

(l)

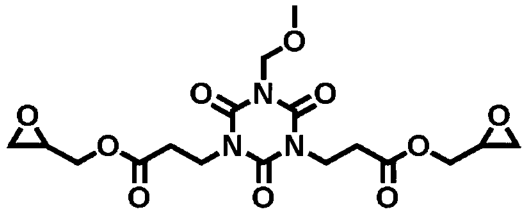

(m)

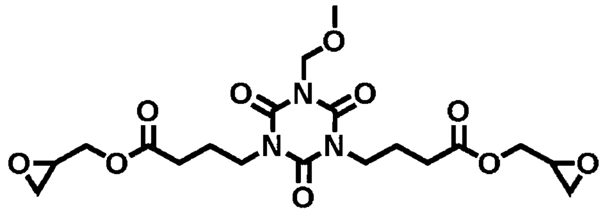

(n)

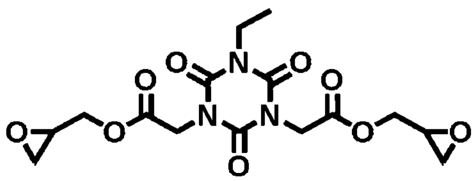

(o)

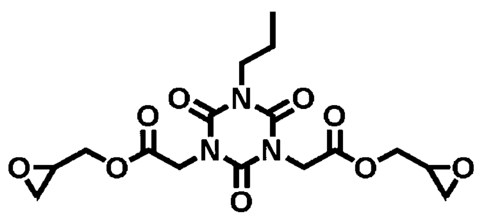

(p)

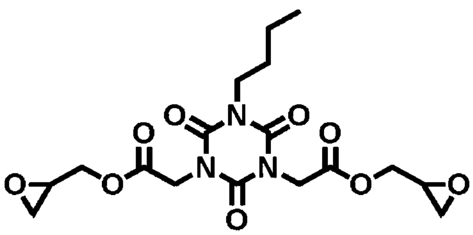

(q)

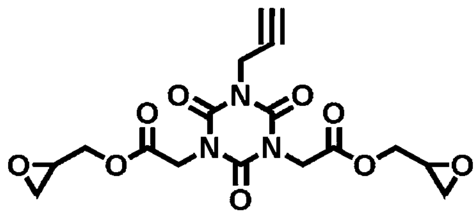

(r)

[Chem. 12]

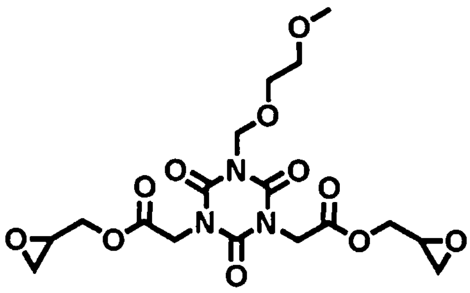

(s)

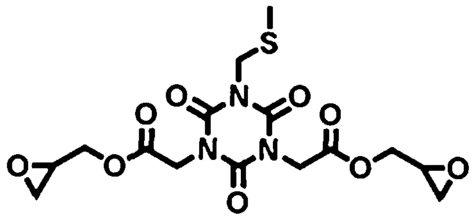

(t)

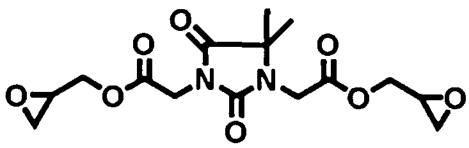

(u)

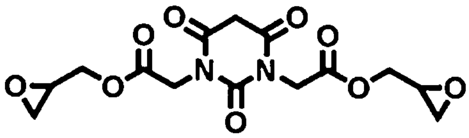

(v)

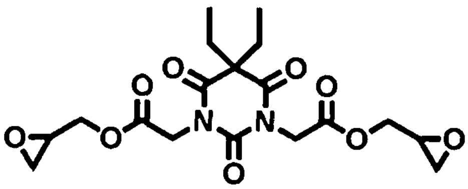

(w)

[Chem. 13]

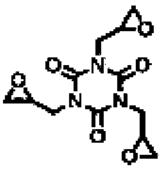

(ac)

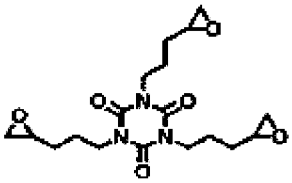

(ad)

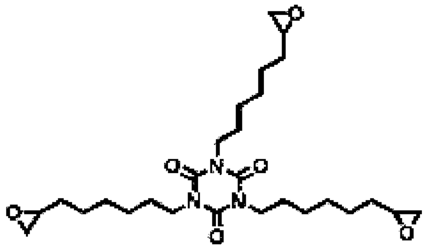

(ae)

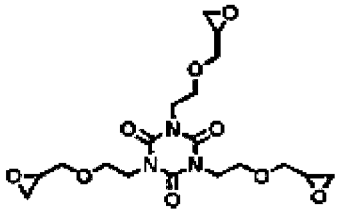

(af)

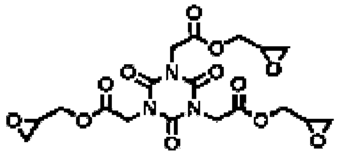

(ag)

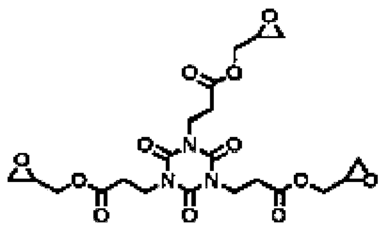

(ah)

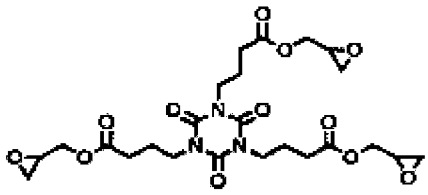

(ai)

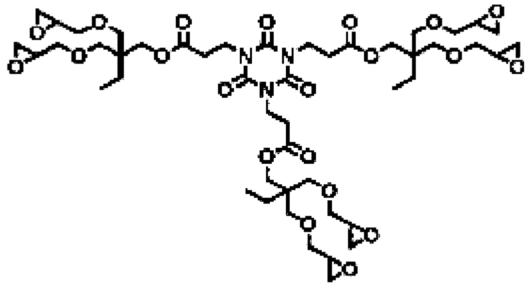

(aj)

[Chem. 14]

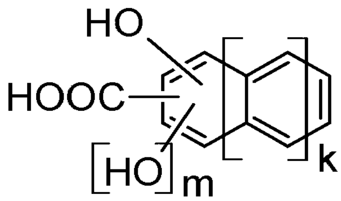

(Y)

(In Formula (Y), m represents an integer of 0 to 4. k represents 0 or 1.)

Examples of the compound represented by Formula (Y) include the following compounds.

[Chem. 15]

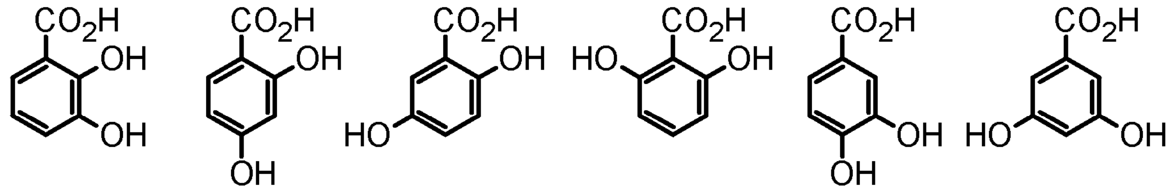

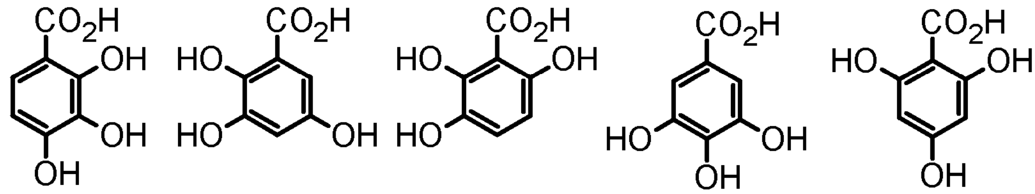

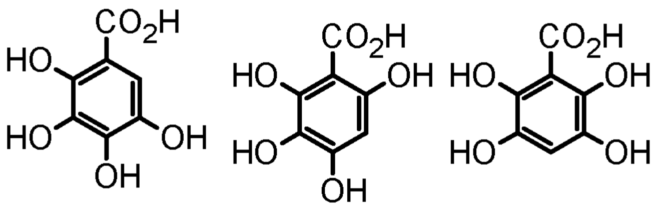

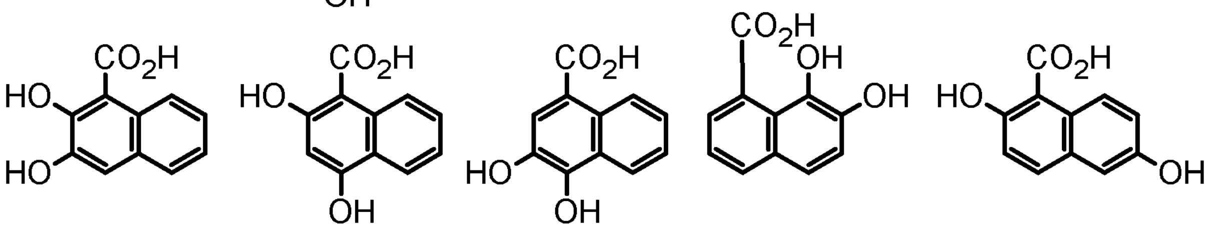

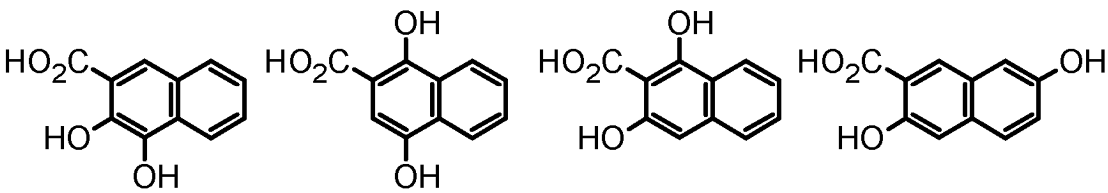

Examples of the compound represented by Formula (A-1-1) include the following compounds.

[Chem. 16]

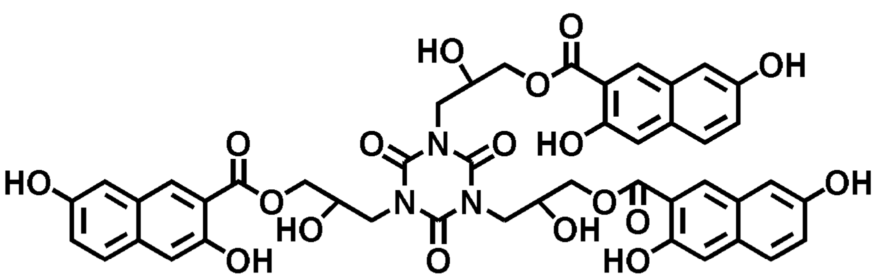

[Chem. 17]

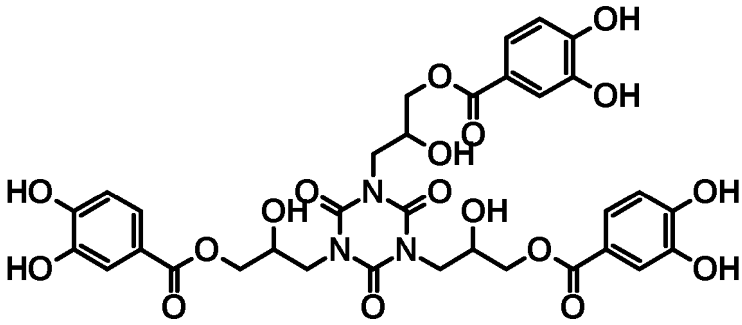

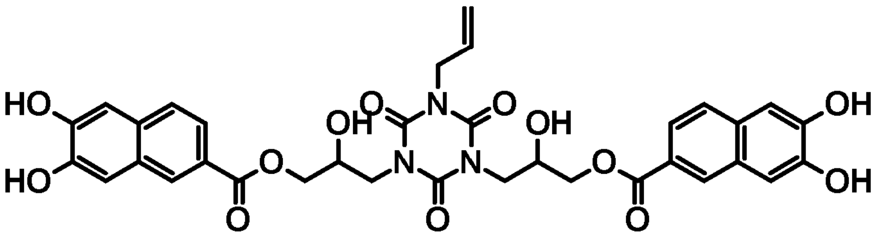

<<<Compound represented by Formula (A-1-2)>>>

[Chem. 18]

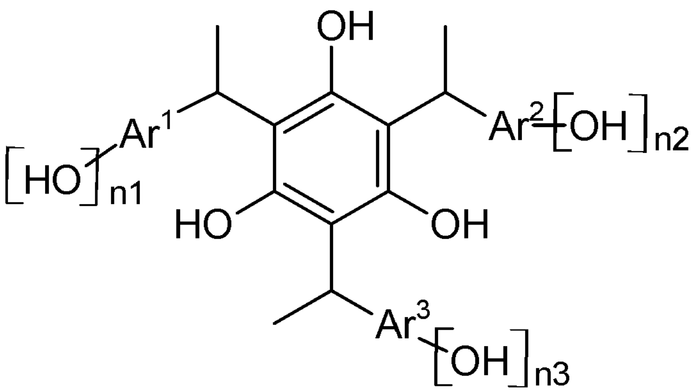

(A-1-2)

(In Formula (A-1-2), $Ar^1$ to $Ar^3$ each independently represent an aromatic hydrocarbon ring.

n1 to n3 each independently represent an integer of 1 to 4.)

Examples of the aromatic hydrocarbon ring include a benzene ring, a naphthalene ring, an anthracene ring, and the like. Among these, a benzene ring and a naphthalene ring are preferable.

n1 to n3 are preferably 1.

Examples of the compound represented by Formula (A-1-2) include the following compounds.

[Chem. 19]

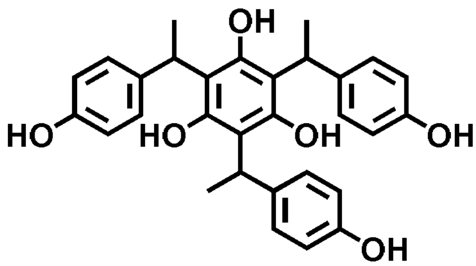

[Chem. 20]

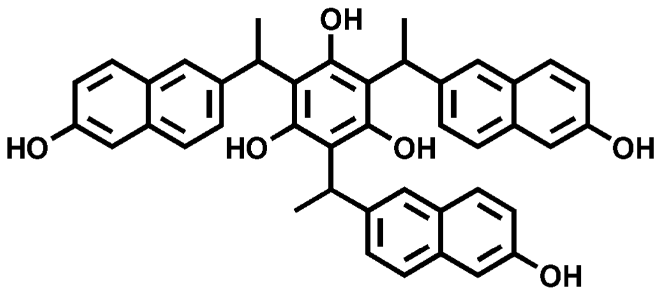

The compound represented by Formula (A-1-2) can be synthesized by, for example, reacting phloroglucinol represented by Formula (A-1-2A) below and a compound represented by Formula (A-1-2B) below. In the reaction, a protecting group of a hydroxy group is used, and deprotection is performed as necessary.

[Chem. 21]

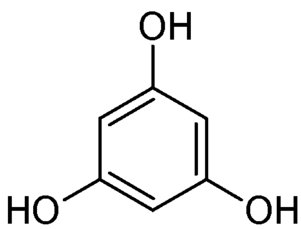

(A-1-2A)

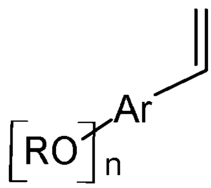

(A-1-2B)

(In Formula (A-1-2B), Ar represents an aromatic hydrocarbon ring.
R represents a hydrogen atom or a protecting group of a hydroxy group.
n1 represents an integer of 1 to 4.)

Examples of the aromatic hydrocarbon ring include a benzene ring, a naphthalene ring, an anthracene ring, and the like. Among these, a benzene ring and a naphthalene ring are preferable.

Examples of the compound represented by Formula (A-1-2B) include tert-butoxystyrene, 2-tert-butoxyvinylnaphthalene, and the like.

<<<Compound represented by Formula (A-1-3)>>>

[Chem. 22]

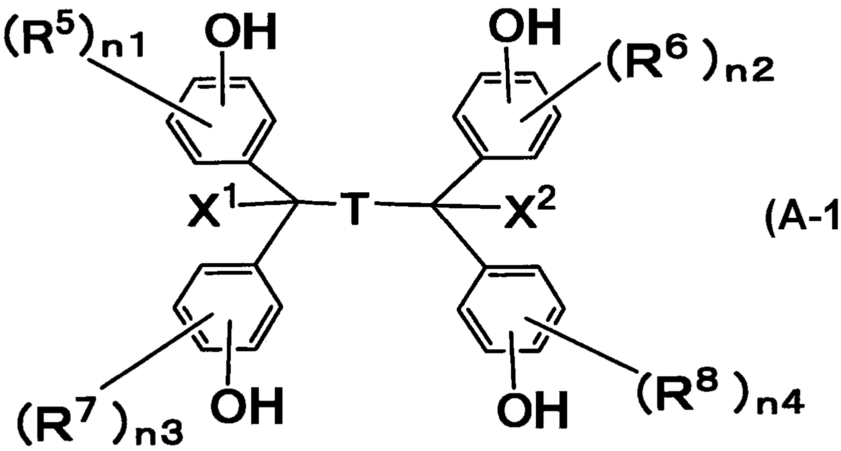

(A-1-3)

(In Formula (A-1-3), T represents a single bond, an alkylene group having 1 to 10 carbon atoms, or an arylene group having 6 to 40 carbon atoms.

$X^1$ and $X^2$ each independently represent a hydrogen atom or a methyl group.

$R^5$ to $R^8$ each independently represent an alkyl group having 1 to 10 carbon atoms or an aryl group having 6 to 40 carbon atoms.

n1 to n4 each independently represent an integer of 0 to 3.)

Examples of the compound represented by Formula (A-1-3) include the following compounds.

[Chem. 23]

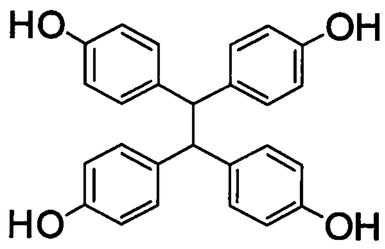

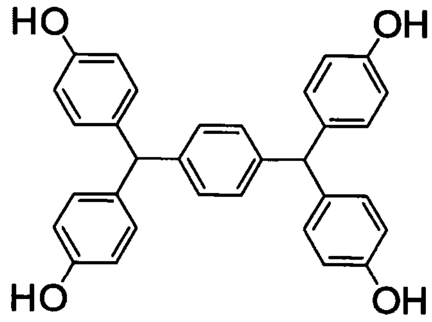

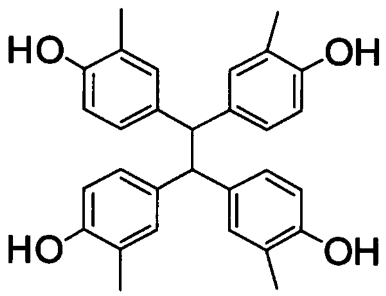

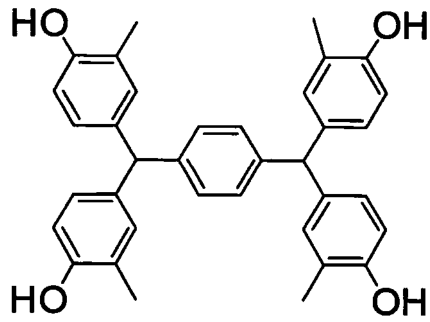

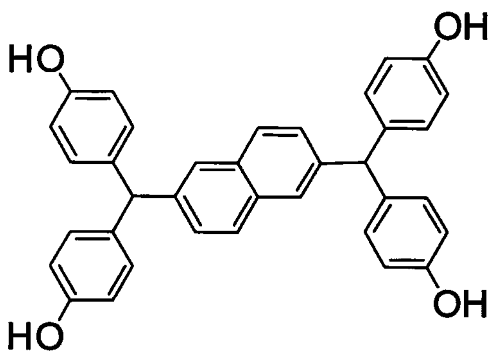

The compound represented by Formula (A-1-3) may be a commercially available product. Examples of the commercially available product include TEP-TPA (manufactured by Asahi Yukizai Corporation).

<<<Compound represented by Formula (A-1-4)>>>

The compound represented by Formula (A-1-4) is tannic acid.

[Chem. 24]

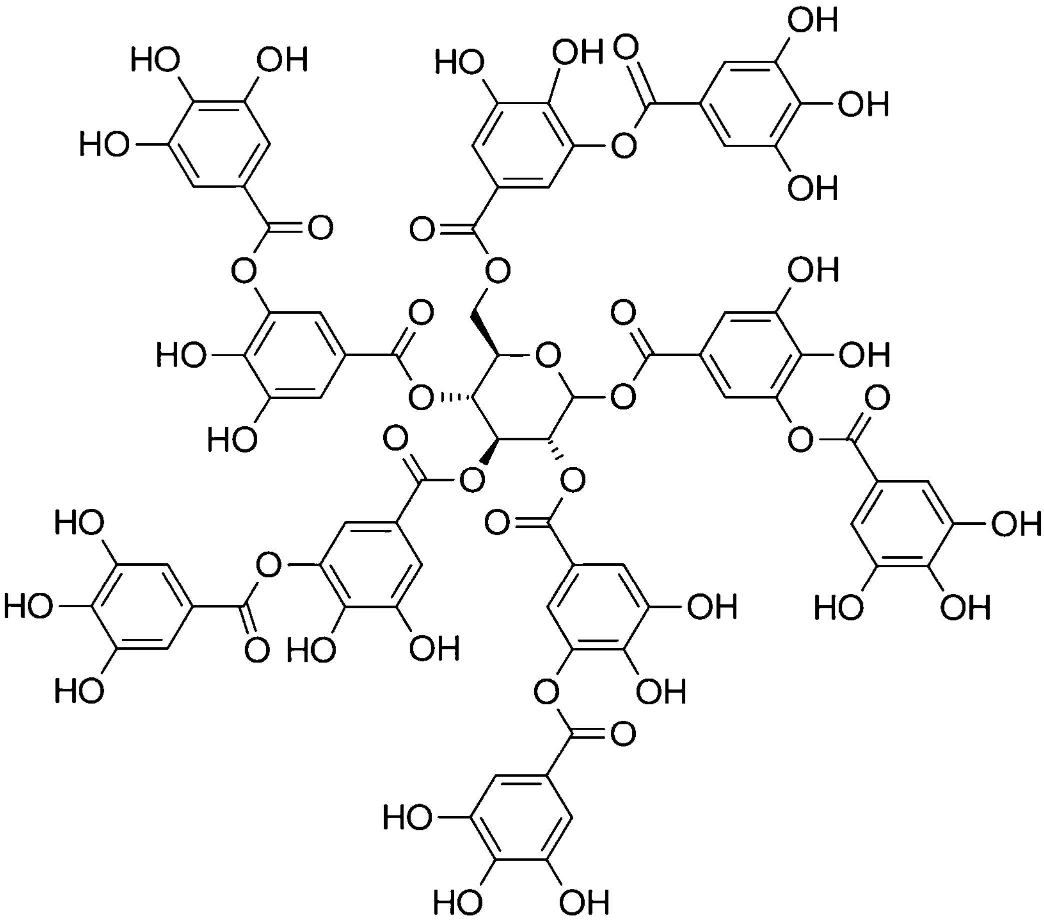

(A-1-4)

The content of the compound (A) in the resist underlayer film-forming composition is not particularly limited, and is preferably 40 mass% to 99 mass%, more preferably 45 mass% to 95 mass%, and particularly preferably 50 mass% to 90 mass% with respect to the film constituent components from the viewpoint of suitably obtaining the effect of the present invention.

In the present invention, the film constituent component means a component other than the solvent contained in the composition.

<Solvent (B)>

The solvent (B) is not particularly limited, and may be water or an organic solvent.

Examples of the organic solvent include an alkylene glycol monoalkyl ether, a monocarboxylic acid ester of an alkylene glycol monoalkyl ether, and the like.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, propylene glycol monoethyl ether, and the like.

Examples of the alkylene group of the monocarboxylic acid ester of an alkylene glycol monoalkyl ether include an alkylene group having 2 to 4 carbon atoms.

Examples of the alkyl group of the monocarboxylic acid ester of an alkylene glycol monoalkyl ether include an alkyl group having 1 to 4 carbon atoms.

Examples of the monocarboxylic acid of the monocarboxylic acid ester of an alkylene glycol monoalkyl ether

include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, propylene glycol propyl ether acetate, and the like.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, $\gamma$-butyrolactone, N-methylpyrrolidone, N,N-dimethylformamide, N,N-dimethylacetamide, and the like.

Among these solvents (B), an alkylene glycol monoalkyl ether and a monocarboxylic acid ester of an alkylene glycol monoalkyl ether are preferable.

One type of these solvents (B) can be used singly or two or more types thereof can be used in combination.

The mass ratio of the organic solvent in the solvent (B) is not particularly limited, but is preferably 50 mass% to 100 mass%.

The content of the solvent (B) in the resist underlayer film-forming composition is not particularly limited, but is preferably 50 mass% to 99.99 mass%, more preferably 75 mass% to 99.95 mass%, and particularly preferably 90 mass% to 99.9 mass%.

<Crosslinking agent (C)>

The crosslinking agent (C) is not particularly limited.

The crosslinking agent (C) has a structure different from that of the compound (A).

As the crosslinking agent (C), an aminoplast crosslinking agent and a phenoplast crosslinking agent are preferable.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include a compound having two or more structures shown below.

[Chem. 25]

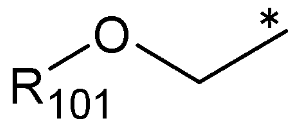

(In the structure, $R_{101}$ represents a hydrogen atom, an alkyl group having 1 to 4 carbon atoms, or an alkoxyalkyl group having 2 to 6 carbon atoms. * represents a binding site.)

The binding site is bonded to, for example, a nitrogen atom, a carbon atom included in an aromatic hydrocarbon ring, or the like.

As $R_{101}$, a hydrogen atom, a methyl group, an ethyl group, or a group represented by the following structure is preferable.

[Chem. 26]

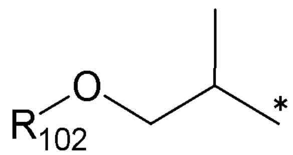

(In the structure, $R_{102}$ represents a hydrogen atom, a methyl group, or an ethyl group. * represents a binding site.)

The crosslinking agent (C) is preferably a melamine compound, a guanamine compound, a glycoluril compound, a urea compound, or a compound having a phenolic hydroxy group. One type of these can be used singly or two or more types thereof can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, a compound in which 1 to 6 methylol groups of hexamethylolmelamine are acyloxymethylated or a mixture thereof, and the like.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, a compound in which 1 to 4 methylol groups of tetramethylolguanamine are acyloxymethylated or a mixture thereof, and the like.

Examples of the glycoluril compound include tetramethylol glycoluril, tetramethoxy glycoluril, tetramethoxymethyl glycoluril, a compound in which 1 to 4 methylol groups of tetramethylol glycoluril are methoxymethylated or a mixture thereof, a compound in which 1 to 4 methylol groups of tetramethylol glycoluril are acyloxymethylated or a mixture thereof, and the like.

The glycoluril compound may be, for example, a glycoluril derivative represented by Formula (1E) below.

[Chem. 27]

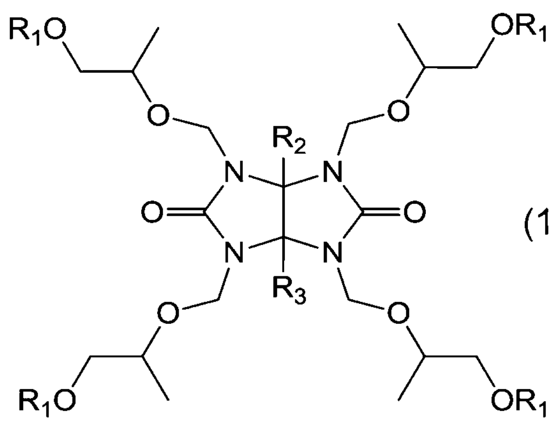

(1E)

(In Formula (1E), four $R_1$'s each independently represent a methyl group or an ethyl group, and $R_2$ and $R_3$ each independently represent a hydrogen atom, an alkyl group having 1 to 4 carbon atoms, or a phenyl group.)

Examples of the glycoluril derivative represented by Formula (1E) include compounds represented by Formulae (1E-1) to (1E-6) below.

[Chem. 28]

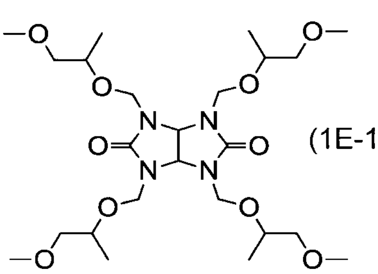
(1E-1)

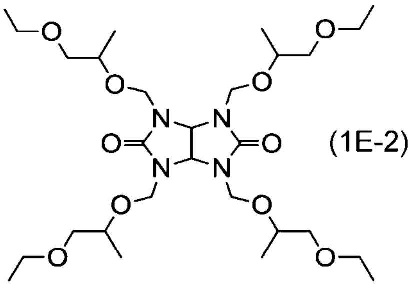
(1E-2)

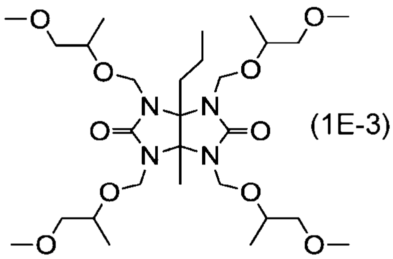
(1E-3)

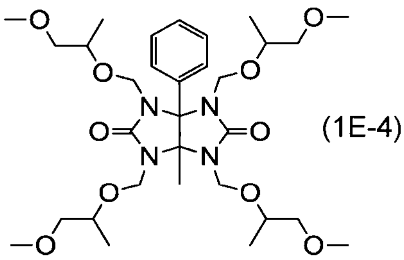
(1E-4)

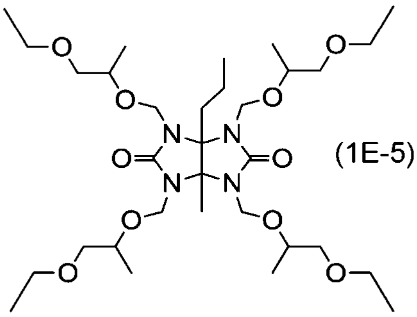
(1E-5)

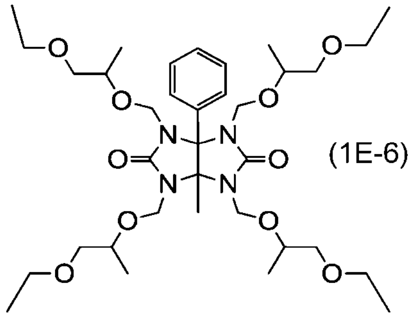
(1E-6)

The glycoluril derivative represented by Formula (1E) is obtained by, for example, allowing a glycoluril derivative represented by Formula (2E) below to react with at least one type of compound represented by Formula (3d) below.

[Chem. 29]

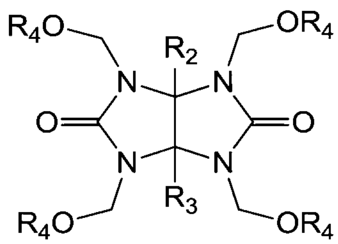
(2E)

(In formula (2E), $R_2$ and $R_3$ each independently represent a hydrogen atom, an alkyl group having 1 to 4 carbon atoms, or a phenyl group, and $R_4$'s each independently represent an alkyl group having 1 to 4 carbon atoms.)

[Chem. 30]

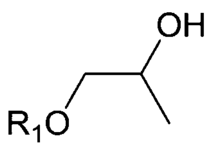
(3d)

(In Formula (3d), $R_1$ represents a methyl group or an ethyl group.)

Examples of the glycoluril derivative represented by formula (2E) include compounds represented by formulae (2E-1) to (2E-4) below. Examples of the compound represented by formula (3d) include compounds represented by formula (3d-1) and formula (3d-2) below.

[Chem. 31]

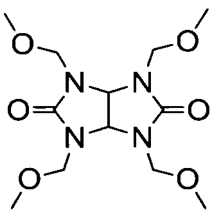
(2E-1)

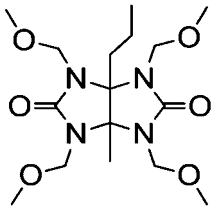
(2E-2)

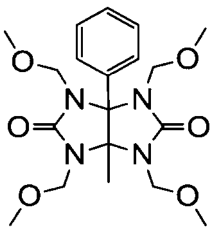
(2E-3)

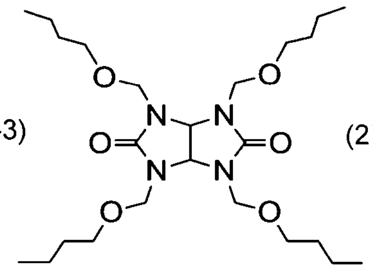
(2E-4)

[Chem. 32]

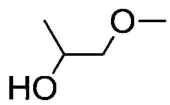
(3d-1)

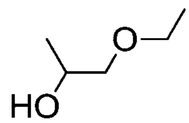
(3d-2)

Examples of the urea compound include tetramethylol urea, tetramethoxy methyl urea, a compound in which 1 to 4 methylol groups of tetramethylol urea are methoxymethylated or a mixture thereof, tetramethoxy ethyl urea, and the like.

Examples of the compound having a phenolic hydroxy group include a compound represented by formula (G-1) or formula (G-2) below.

[Chem. 33]

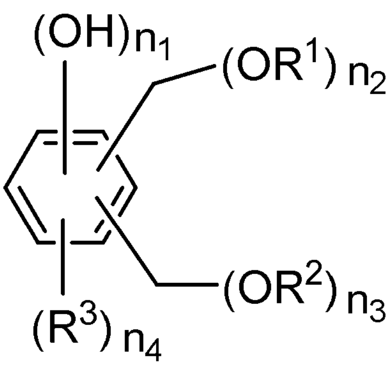
(G-1)

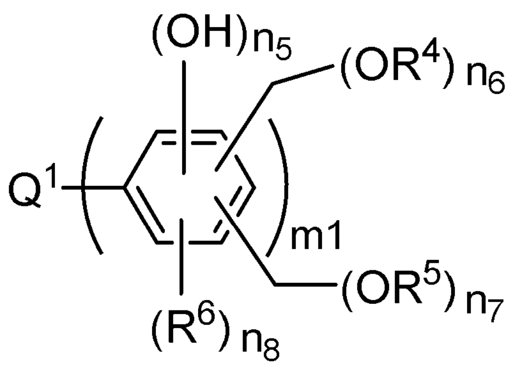
(G-2)

(In Formula (G-1) and formula (G-2), $Q^1$ represents a single bond or an m1-valent organic group.
$R^1$ and $R^4$ each represent an alkyl group having 2 to 10 carbon atoms or an alkyl group having 2 to 10 carbon atoms and having an alkoxy group having 1 to 10 carbon atoms.

$R^2$ and $R^5$ each represent a hydrogen atom or a methyl group.
$R^3$ and $R^6$ each represent an alkyl group having 1 to 10 carbon atoms or an aryl group having 6 to 40 carbon atoms.
$n_1$ represents an integer that meets $1 \leq n_1 \leq 3$, $n_2$ represents an integer that meets $2 \leq n_2 \leq 5$, $n_3$ represents an integer that meets $0 \leq n_3 \leq 3$, $n_4$ represents an integer that meets $0 \leq n_4 \leq 3$, and an integer that meets $3 \leq (n_1 + n_2 + n_3 + n_4) \leq 6$.
$n_5$ represents an integer that meets $1 \leq n_5 \leq 3$, $n_6$ represents an integer that meets $1 \leq n_6 \leq 4$, $n_7$ represents an integer that meets $0 \leq n_7 \leq 3$, $n_8$ represents an integer that meets $0 \leq n_8 \leq 3$, and an integer that meets $2 \leq (n_5 + n_6 + n_7 + n_8) \leq 5$.
m1 represents an integer of 2 to 10.)

Examples of the compound having a phenolic hydroxy group include a compound represented by formula (G-3) or formula (G-4) below.
The compound represented by formula (G-1) or formula (G-2) may be obtained by a reaction of a compound represented by formula (G-3) or formula (G-4) below with a hydroxyl group-containing ether compound or an alcohol having 2 to 10 carbon atoms.

[Chem. 34]

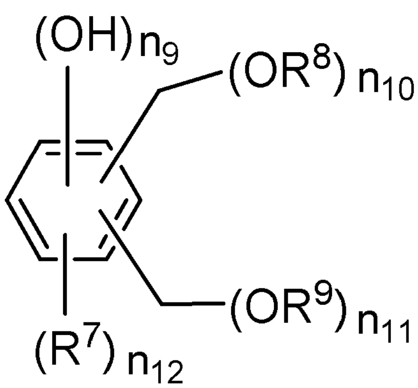

(G-3)

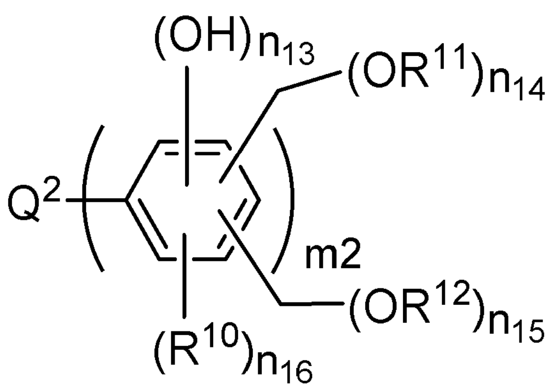

(G-4)

(In formula (G-3) and formula (G-4), $Q^2$ represents a single bond or an m2-valent organic group.
$R^8$, $R^9$, $R^{11}$, and $R^{12}$ each represent a hydrogen atom or a methyl group.
$R^7$ and $R^{10}$ each represent an alkyl group having 1 to 10 carbon atoms or an aryl group having 6 to 40 carbon atoms.
$n_9$ represents an integer that meets $1 \leq ng \leq 3$, $n_{10}$ represents an integer that meets $2 \leq n_{10} \leq 5$, $n_{11}$ represents an integer that meets $0 \leq n_{11} \leq 3$, and $n_{12}$ represents an integer that meets $0 \leq n_{12} \leq 3$, and an integer that meets $3 \leq (n_9 + n_{10} + n_{11} + n_{12}) \leq 6$.
$n_{13}$ represents an integer that meets $1 \leq n_{13} \leq 3$, $n_{14}$ represents an integer that meets $1 \leq n_{14} \leq 4$, $n_{15}$ represents an integer that meets $0 \leq n_{15} \leq 3$, and $n_{16}$ represents an integer that meets $0 \leq n_{16} \leq 3$, and an integer that meets $2 \leq (n_{13} + n_{14} + n_{15} + n_{16}) \leq 5$.
m2 represents an integer of 2 to 10.)

Examples of the m2-valent organic group in $Q^2$ include an m2-valent organic group having 1 to 4 carbon atoms.
Examples of the compound represented by formula (G-1) or formula (G-2) include the following compounds.

[Chem. 35]

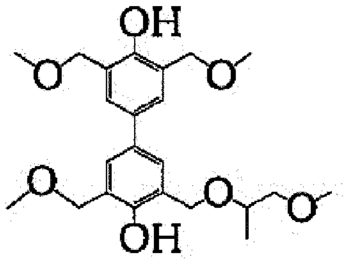

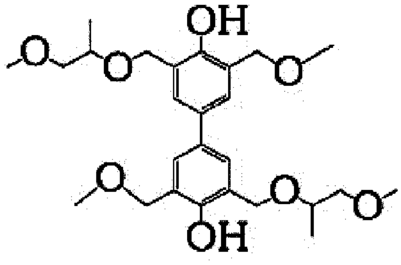

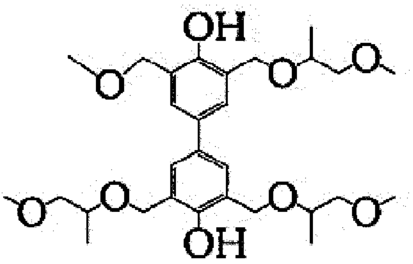

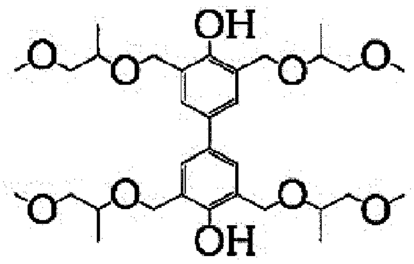

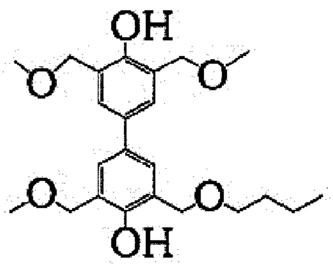

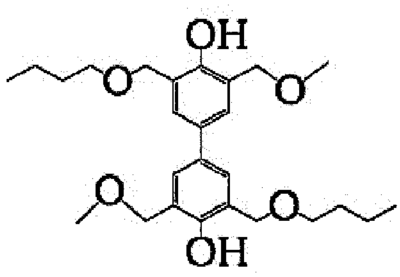

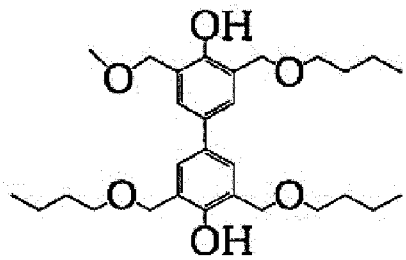

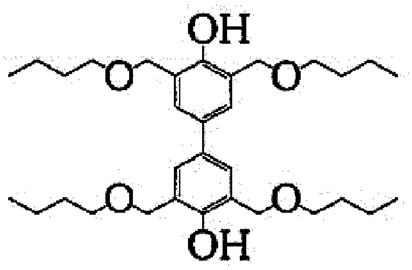

[Chem. 36]

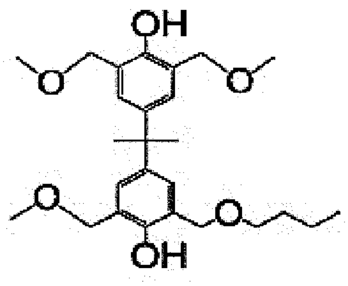

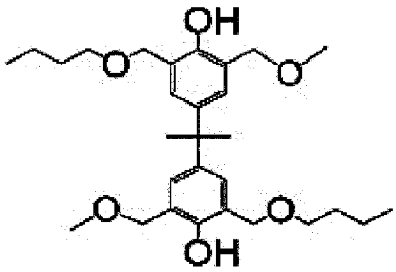

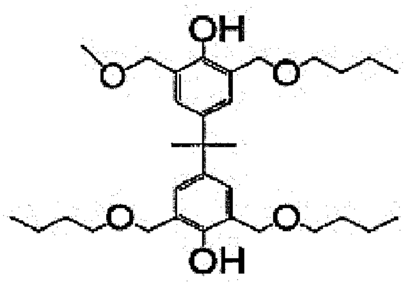

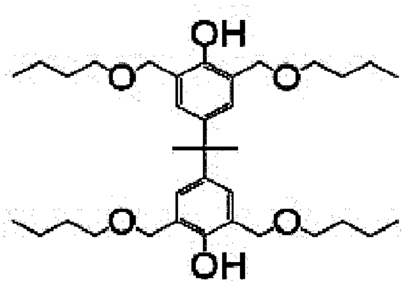

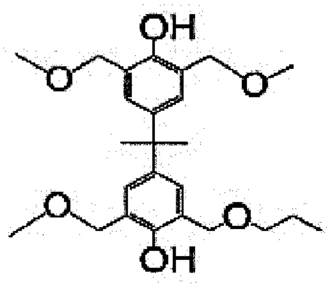

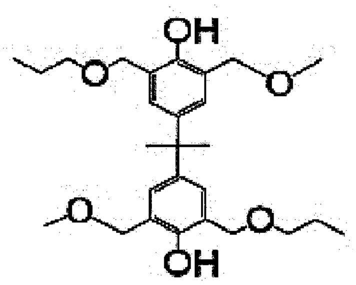

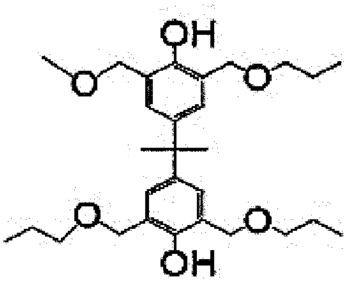

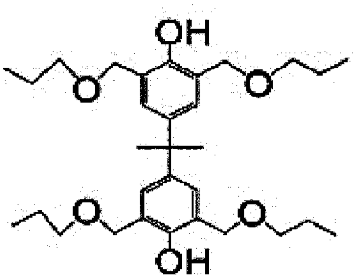

[Chem. 37]

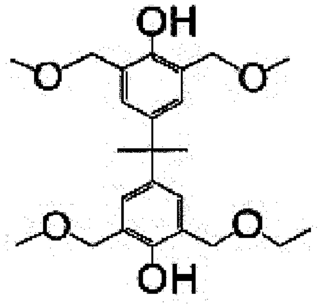

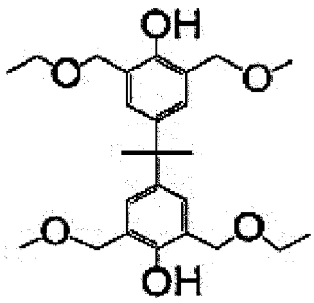

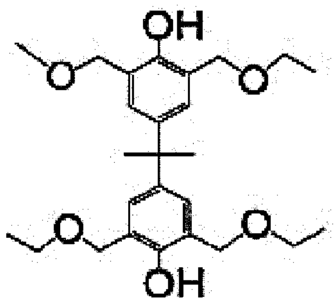

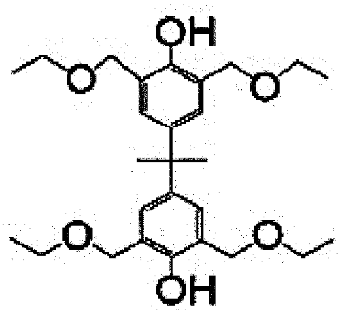

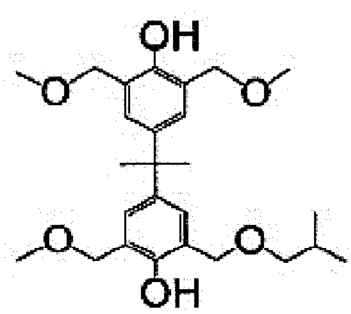

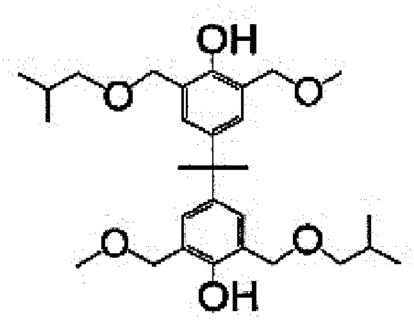

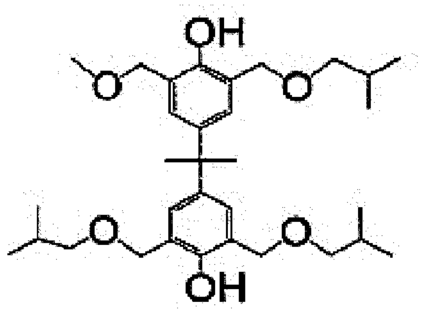

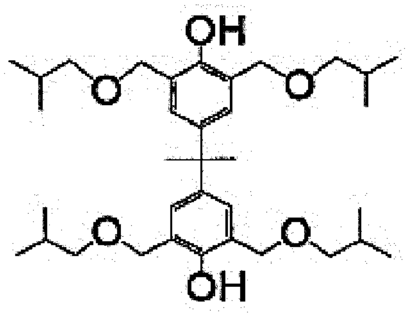

[Chem. 38]

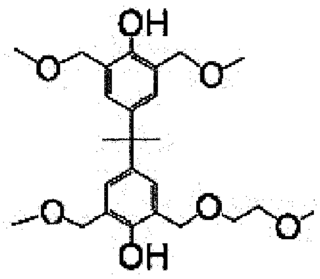

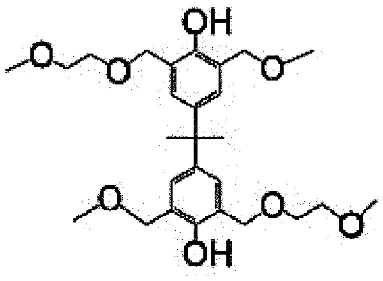

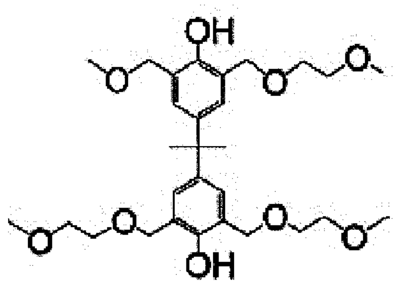

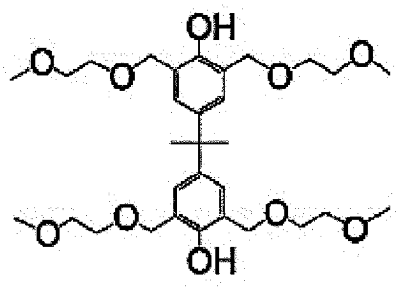

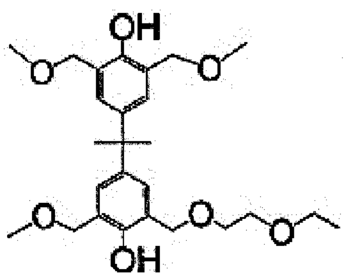

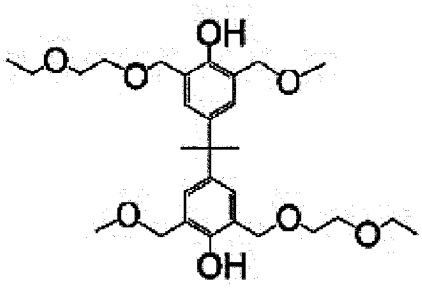

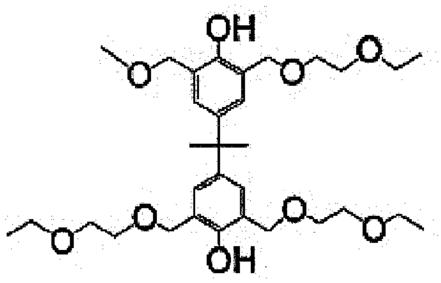

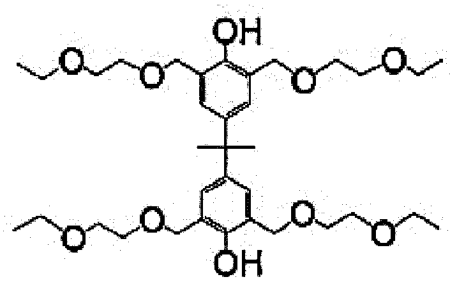

[Chem. 39]

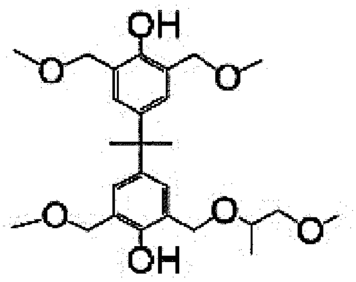
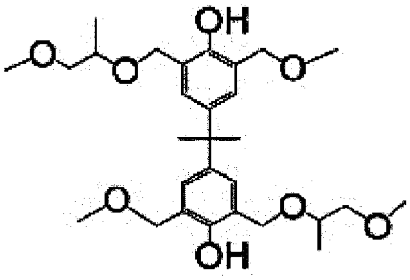
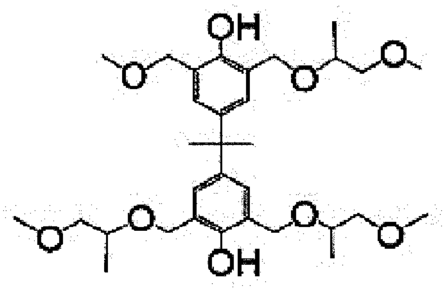
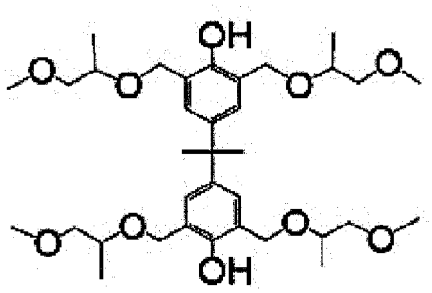
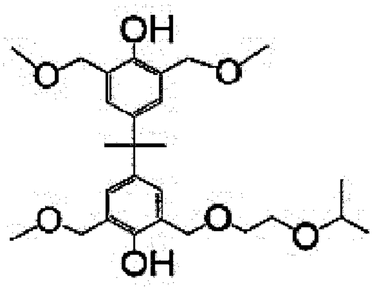
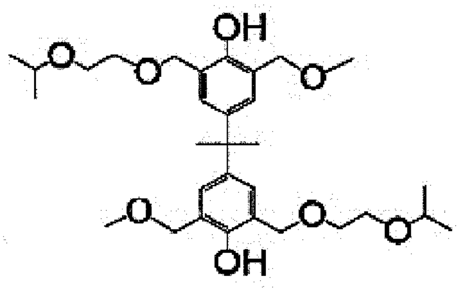
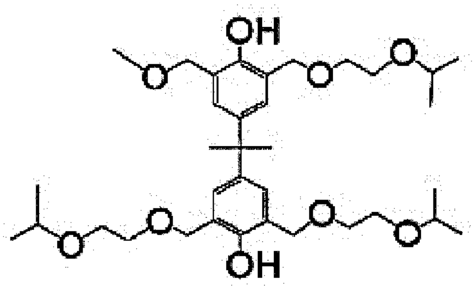
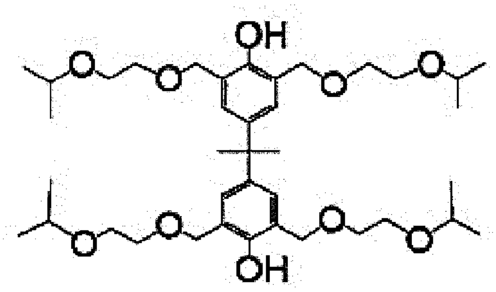

Examples of the compound represented by formula (G-3) or formula (G-4) include the following compounds.

[Chem. 40]

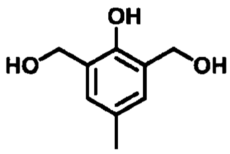
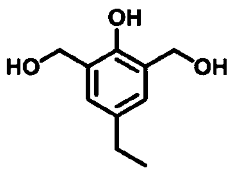
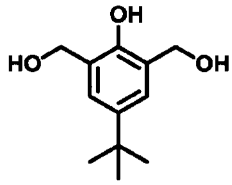
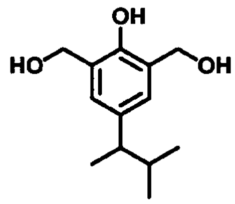

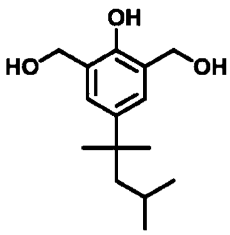
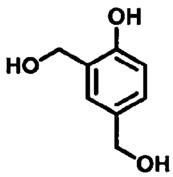
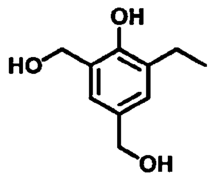

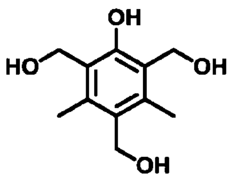
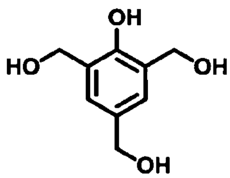
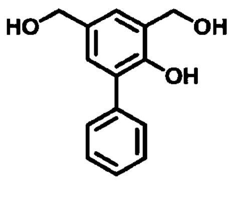
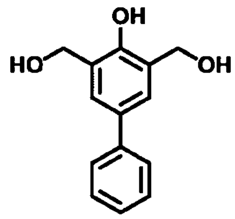

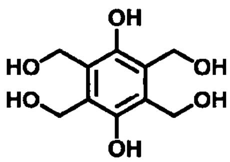
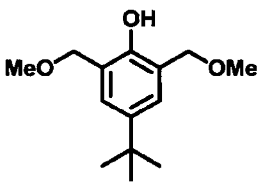
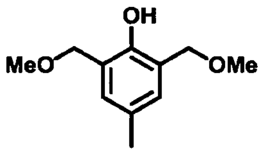

[Chem. 41]

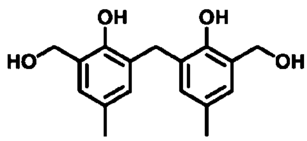
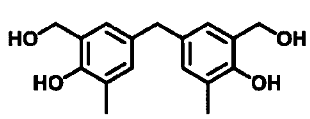
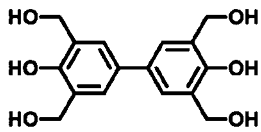
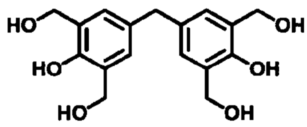
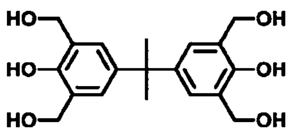
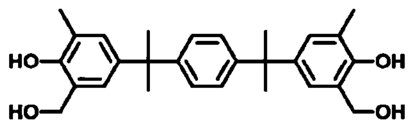
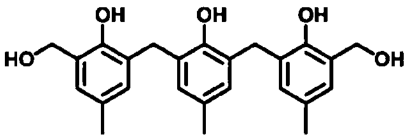
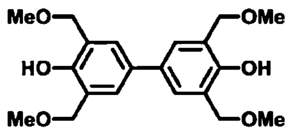
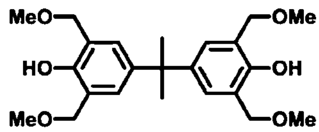
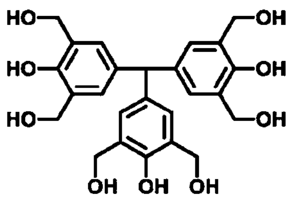
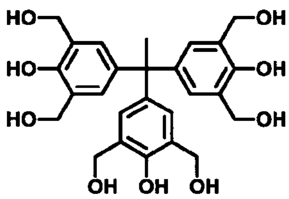
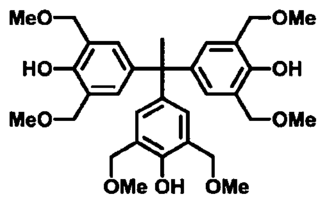

(In the above formulas, Me represents a methyl group.)

The compounds are available as products of Asahi Organic Chemicals Industry Co., Ltd. and Honshu Chemical Industry Co., Ltd. Examples of the products include TMOM-BP (trade name) manufactured by Asahi Organic Chemicals Industry Co., Ltd.

Among the compounds, the glycoluril compound is preferable. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferable, and tetramethoxymethyl glycoluril is more preferable.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% with respect to the compound (A).

<Curing catalyst (D)>

As the curing catalyst (D) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium p-toluenesulfonate (pyridinium p-toluenesulfonic acid), pyridinium phenolsulfonate, pyridinium p-hydroxybenzenesulfonate (p-phenolsulfonic acid pyridinium salt), pyridinium trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine p-toluenesulfonate, N-methylmorpholine p-hydroxybenzenesulfonate, and N-methylmorpholine 5-sulfosalicylate.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, sulfonium salt compounds

such as triphenylsulfonium hexafluoroantimonate, triphenylsulfonium nonafluoronormalbutanesulfonate, triphenylsulfonium camphorsulfonate, and triphenylsulfonium trifluoromethanesulfonate, and the like.

Examples of the sulfonimide compounds include N-(trifluoromethanesulfonyloxy) succinimide, N-(nonafluoronormalbutanesulfonyloxy) succinimide, N-(camphorsulfonyloxy) succinimide, N-(trifluoromethanesulfonyloxy) naphthalimide, and the like.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, methylsulfonyl-p-toluenesulfonyl diazomethane, and the like.

As the curing catalyst (D), only one type can be used, or two or more types can be used in combination.

In the case of using the curing catalyst (D), the content ratio of the curing catalyst (D) is, for example, 0.1 mass% to 50 mass%, and preferably 1 mass% to 30 mass% with respect to the crosslinking agent (C).

<Other components>

To the resist underlayer film-forming composition, a surfactant can be further added in order to further improve the coating property against surface unevenness without generating a pinhole, a striation, and the like.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl allyl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (trade name, manufactured by Tochem Products Co., Ltd.), MEGAFAC F171, F173, and R-30 (trade name, manufactured by DIC Corporation), Fluorad FC430 and FC431 (trade name, manufactured by Sumitomo 3M Limited), Asahi Guard AG710, Surflon S-382, SC101, SC102, SC103, SC104, SC105, and SC106 (trade name, manufactured by AGC Corporation), an organosiloxane polymer KP341 (manufactured by Shin-Etsu Chemical Co., Ltd.), and the like.

The blending amount of such a surfactant is usually 2.0 mass% or less, and preferably 1.0 mass% or less with respect to the total solid content of the resist underlayer film-forming composition.

These surfactants may be added alone, or two or more types thereof can also be added in combination.

The amount of the solid content in the resist underlayer film-forming composition of the present invention, that is, the components excluding the solvent is, for example, 0.01 mass% to 10 mass%.

The resist underlayer film-forming composition of the present invention is preferably a resist underlayer film-forming composition for EUV (extreme ultraviolet) or electron beam lithography.

For example, the resist underlayer film-forming composition does not contain a light absorber.

In addition, for example, the resist underlayer film-forming composition does not contain a polymer having a - NH-C(=S)-O- bond.

In addition, for example, the resist underlayer film-forming composition does not contain a polymer having a structural unit represented by Formula (Z-1) below.

[Chem. 42]

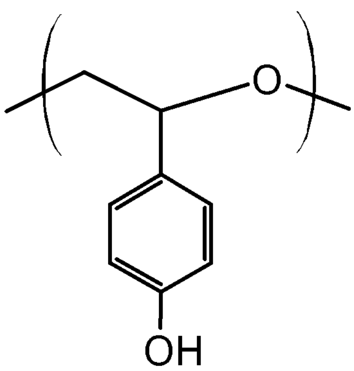

(Z-1)

In addition, for example, the resist underlayer film-forming composition does not contain a polymer having a structural unit represented by Formula (Z-2) below.

[Chem. 43]

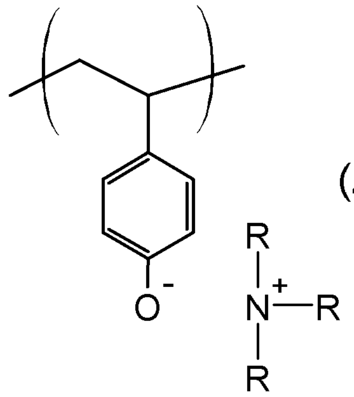

(Z-2)

(In Formula (Z-2), R's each independently represent a hydrogen atom or an alkyl group having 1 to 4 carbon atoms.)

(Resist underlayer film)

A resist underlayer of the present invention is a cured product of the above-described resist underlayer film-forming composition.

The resist underlayer film can be produced, for example, by applying the above-described resist underlayer film-forming composition onto a semiconductor substrate and baking the composition.

The atomic percentage of oxygen in the phenolic hydroxy group in the resist underlayer film is, for example, 2.00% or more, preferably 2.00% or more and 30.00% or less, and more preferably 3.00% or more and 20.00% or less.

The atomic percentage of oxygen in the phenolic hydroxy group in the resist underlayer film can be obtained by, for example, the following method.

The silicon wafer on which the resist underlayer film has been formed is cut into a size of about 0.5 × 1 cm and dried in a vacuum for 20 hours or longer. After that, the silicon wafer is sealed in a 6.0 × 7.5 cm weighing bottle together with 3 ml of trifluoroacetic anhydride, and a hydrogen atom in the phenolic hydroxy group is substituted with a trifluoroacetyl group by a gas phase chemical modification method at a temperature of 25°C. Regarding the reaction time, a time required to reach the reaction equilibrium is confirmed, and the reaction time is set thereto for each composition. Furthermore, unreacted trifluoroacetic anhydride and trifluoroacetic acid generated as a by-product are removed by 20 hours or longer of vacuum drying. After that, the number of each atom constituting the film is measured using X-ray photoelectron spectroscopy (Quanterar SXM) in which an AlKa ray is used as a radiation source (excluding hydrogen). In addition, the atomic percentage ($R_{OH}$ [atom%]) of oxygen in the phenolic hydroxy group in the resist underlayer film is obtained using the following formula.

[Math. 2]

$$R_{\mathrm{OH}}[atom\%] = \frac{F}{A} \times \frac{1}{3} \times 100$$

F: Number of fluorine atoms
A: Total number of atoms (hydrogen atoms are excluded)

In a case where the resist underlayer film before the gas-phase chemical modification method has a fluorine atom, the fluorine atom is not included in F in the mathematical formula.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using a semiconductor substrate having a surface on which an inorganic film is formed, the inorganic film is formed with, for example, an atomic layer deposition (ALD) method, a chemical vapor deposition (CVD) method, a reactive sputtering method, an ion plating method, a vacuum deposition method, or a spin coating method (spin-on-glass: SOG). Examples of the inorganic film include a polysilicon film, a silicon oxide film, a silicon nitride film, a borophospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Then, the composition is baked using a heating unit such as a hot plate to form a resist underlayer film. The baking conditions are appropriately selected from a baking temperature of 100°C to 400°C and a baking time of 0.3 minutes to 60 minutes. It is preferable that the baking temperature is 120°C to 350°C and the baking time is 0.5 minutes to 30 minutes, and it is more preferable that the baking temperature is 150°C to 300°C and the baking time is 0.8 minutes to 10 minutes.

The film thickness of the resist underlayer film is, for example, 0.001 μm (1 nm) to 10 μm, 0.002 μm (2 nm) to 1 μm, 0.005 μm (5 nm) to 0.5 μm (500 nm), 0.001 μm (1 nm) to 0.05 μm (50 nm), 0.002 μm (2 nm) to 0.05 μm (50 nm), 0.003 μm (3 nm) to 0.05 μm (50 nm), 0.004 μm (4 nm) to 0.05 μm (50 nm), 0.005 μm (5 nm) to 0.05 μm (50 nm), 0.003 μm (3 nm) to 0.03 μm (30 nm), 0.003 μm (3 nm) to 0.02 μm (20 nm), 0.005 μm (5 nm) to 0.02 μm (20 nm), 0.005 μm (5 nm) to 0.02 μm (20 nm), 0.003 μm (3 nm) to 0.01 μm (10 nm), 0.005 μm (5 nm) to 0.01 μm (10 nm), 0.003 μm (3 nm) to 0.006 μm (6 nm), or 0.005 μm (5 nm).

The film thickness of the resist underlayer film is preferably 2 nm or more and 20 nm or less from the viewpoint of suitably obtaining the effect of the present invention.

The method for measuring a film thickness of the resist underlayer film in the present description is as follows.

· Measurement apparatus name: Ellipsometric Film Thickness Measurement System RE-3100 (SCREEN Semiconductor Solutions Co., Ltd.)
· Single wavelength ellipsometer (SWE) mode
· Arithmetic average of eight points (for example, eight points are measured at intervals of 1 cm in the X direction of the wafer)

(Laminate)

The laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

(Method for producing semiconductor element and pattern forming method)

The method for producing a semiconductor element of the present invention includes at least the following steps.

· a step of forming a resist underlayer film on a semiconductor substrate using the resist underlayer film-forming composition of the present invention
· a step of forming a resist film on the resist underlayer film

The pattern forming method of the present invention includes at least the following steps.

· a step of forming a resist underlayer film on a semiconductor substrate using the resist underlayer film-forming composition of the present invention
· a step of forming a resist film on the resist underlayer film
· a step of irradiating the resist film with light or an electron beam, and then developing the resist film to obtain a resist pattern
· a step of etching the resist underlayer film using the resist pattern as a mask

Usually, a resist layer is formed on the resist underlayer film.

The film thickness of the resist layer is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (such as application and baking of a resist composition) is not particularly limited as long as it responds to light or an electron beam (EB) used for irradiation. Both a negative photoresist and a positive photoresist can be used.

In the present description, a resist responding to EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an

acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, a resist containing a metal element, and the like. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, AR2772 and SEPR430 (trade names) manufactured by Shin-Etsu Chemical Co., Ltd, and the like. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used that include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525, WO 2018/190088, JP 2018-070596, JP 2018-028090, JP 2016-153409, JP 2016-130240, JP 2016-108325, JP 2016-047920, JP 2016-035570, JP 2016-035567, JP 2016-035565, JP 2019-101417, JP 2019-117373, JP 2019-052294, JP 2019-008280, JP 2019-008279, JP 2019-003176, JP 2019-003175, JP 2018-197853, JP 2019-191298, JP 2019-061217, JP 2018-045152, JP 2018-022039, JP 2016-090441, JP 2015-10878, JP 2012-168279, JP 2012-022261, JP 2012-022258, JP 2011-043749, JP 2010-181857, JP 2010-128369, WO 2018/031896, JP 2019-113855, WO 2017/156388, WO 2017/066319, JP 2018-41099, WO 2016/065120, WO 2015/026482, JP 2016-29498, JP 2011-253185, and the like, but the resist compositions are not limited thereto.

Examples of the resist composition include the following compositions.

An active ray-sensitive or radiation-sensitive resin composition containing a resin A having a repeating unit having an acid-decomposable group in which a polar group is protected by a protecting group to be removed by an action of an acid, and a compound represented by general formula (121) below.

[Chem. 44]

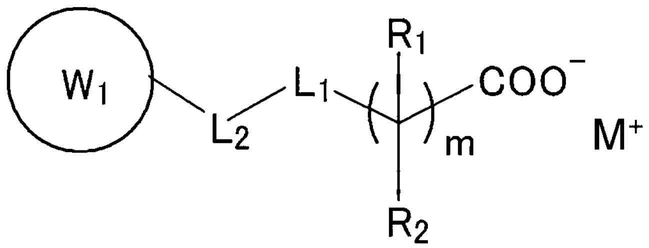

(121)

In general formula (121), m represents an integer of 1 to 6.

$R_1$ and $R_2$ each independently represent a fluorine atom or a perfluoroalkyl group.

$L_1$ represents -O-, -S-, -COO-, $-SO_2-$, or $-SO_3-$.

$L_2$ represents an alkylene group which may have a substituent, or a single bond.

$W_1$ represents a cyclic organic group which may have a substituent.

$M^+$ represents a cation.

A metal-containing film-forming composition for extreme ultraviolet or electron beam lithography, containing a compound having a metal-oxygen covalent bond and a solvent, in which metal elements included in the compound belong to periods 3 to 7 of groups 3 to 15 in the periodic table.

A radiation-sensitive resin composition that contains a polymer having a first structural unit represented by formula (31) below and a second structural unit represented by formula (32) below and containing an acid-dissociable group, and that contains an acid generator.

[Chem. 45]

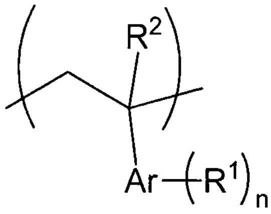 (31) 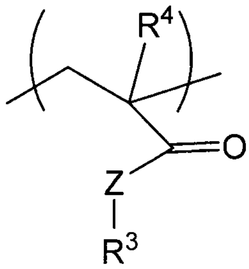 (32)

(In formula (31), Ar is a group obtained by removing (n + 1) hydrogen atoms from an arene having 6 to 20 carbon atoms, $R^1$ is a hydroxy group, a sulfanyl group, or a monovalent organic group having 1 to 20 carbon atoms, n is an integer of 0 to 11, when n is 2 or more, a plurality of $R^1$'s are identical or different, and $R^2$ is a hydrogen atom, a fluorine atom, a methyl group, or a trifluoromethyl group. In formula (32), $R^3$ is a monovalent group having 1 to 20 carbon atoms and containing the acid-dissociable group, Z is a single bond, an oxygen atom, or a sulfur atom, and $R^4$ is a hydrogen atom, a fluorine atom, a methyl group, or a trifluoromethyl group.)

A resist composition that contains a resin (A1) including a structural unit having a cyclic carbonate structure, a structural unit represented by the following formula, and a structural unit having an acid-unstable group, and that contains an acid generator.

[Chem. 46]

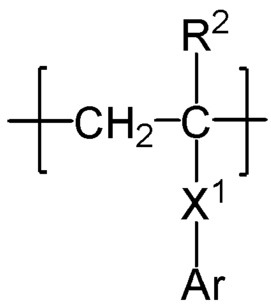

[In the Formula,
$R^2$ represents an alkyl group which has 1 to 6 carbon atoms and may have a halogen atom or represents a hydrogen atom or a halogen atom, $X^1$ represents a single bond, -CO-O-*, or -CO-$NR^4$-*, * represents a binding site with -Ar, $R^4$ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.]

Examples of the resist film include the following resist film.

A resist film including a base resin including a repeating unit represented by Formula (a1) below and/or a repeating unit represented by Formula (a2) below, and a repeating unit that generates an acid bonded to a polymer main chain by exposure.

[Chem. 47]

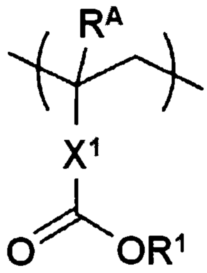

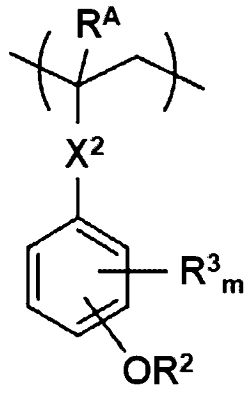

(a1) (a2)

(In Formula (a1) and Formula (a2), $R^{A}$'s are each independently a hydrogen atom or a methyl group, $R^1$ and $R^2$ are each independently a tertiary alkyl group having 4 to 6 carbon atoms, $R^3$'s are each independently a fluorine atom or a methyl group, m is an integer of 0 to 4, $X^1$ is a single bond, a phenylene group, a naphthylene group, or a linking group having 1 to 12 carbon atoms and including at least one type selected from an ester bond, a lactone ring, a phenylene group, and a naphthylene group, and $X^2$ is a single bond, an ester bond, or an amide bond.)

Examples of the resist material include the following resist material.

A resist material containing a polymer having a repeating unit represented by Formula (b1) or Formula (b2) below.

[Chem. 48]

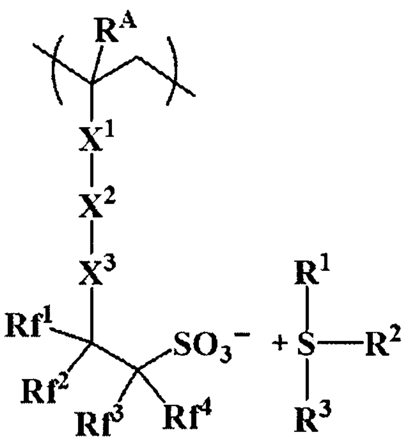

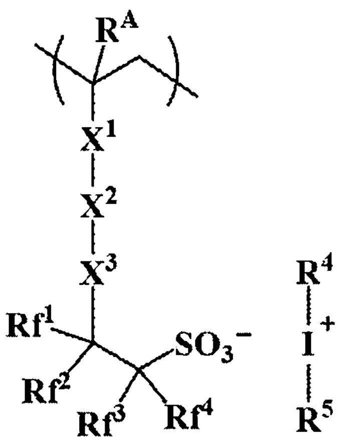

(b1) (b2)

(In Formula (b1) and Formula (b2), $R^A$ is a hydrogen atom or a methyl group, $X^1$ is a single bond or an ester group, $X^2$ is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in $X^2$ is substituted with a bromine atom, $X^3$ is a single bond, an ether group, an ester group, or a linear, branched, or cyclic alkylene group having 1 to 12 carbon atoms, and some of methylene groups included in the alkylene group may be substituted with an ether group or an ester group, $Rf^1$ to $Rf^4$ are each independently a hydrogen atom, a fluorine atom, or a trifluoromethyl group, and at least one of $Rf^1$ to $Rf^4$ is a fluorine atom or a trifluoromethyl group, $Rf^1$ and $Rf^2$ may be combined to form a carbonyl group, $R^1$ to $R^5$ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxy group, a halogen atom, an oxo

group, a cyano group, an amide group, a nitro group, a sultone group, a sulfone group, or a sulfonium salt-containing group, and some of methylene groups included in these groups may be substituted with an ether group, an ester group, a carbonyl group, a carbonate group, or a sulfonic acid ester group, and $R^1$ and $R^2$ may be bonded to form a ring together with a sulfur atom to which $R^1$ and $R^2$ are bonded.)

A resist material containing a base resin including a polymer having a repeating unit represented by Formula (a) below.

[Chem. 49]

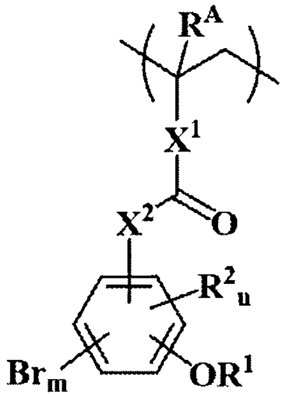

(a)

(In Formula (a), $R^A$ is a hydrogen atom or a methyl group, $R^1$ is a hydrogen atom or an acid-unstable group, $R^2$ is a linear, branched, or cyclic alkyl group having 1 to 6 carbon atoms or a halogen atom other than bromine, $X^1$ is a single bond, a phenylene group, or a linear, branched, or cyclic alkylene group which has 1 to 12 carbon atoms and may include an ester group or a lactone ring, $X^2$ is -O-, - O-$CH_2$-, or -NH-, m is an integer of 1 to 4, u is an integer of 0 to 3, provided that m + u is an integer of 1 to 4.)

A resist composition generating an acid by exposure and having solubility in a developer changed by an action of an acid, the resist composition containing

a base material component (A) that has a solubility in a developer changed by an action of an acid, and a fluorine additive component (F) that exhibits decomposability in an alkaline developer,

in which the fluorine additive component (F) contains a fluororesin component (F1) that has a constituent unit (f1) containing a base-dissociable group and a constituent unit (f2) containing a group represented by General Formula (f2-r-1) below.

[Chem. 50]

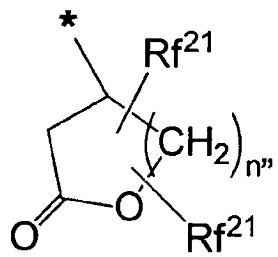

(f 2 - r - 1)

[In Formula (f2-r-1), $Rf^{21}$'s are each independently a hydrogen atom, an alkyl group, an alkoxy group, a hydroxy group, a hydroxyalkyl group, or a cyano group, n" is an integer of 0 to 2, and * is a binding site.]

The constituent unit (f1) includes a constituent unit represented by General Formula (f1-1) below or a constituent unit represented by General Formula (f1-2) below.

[Chem. 51]

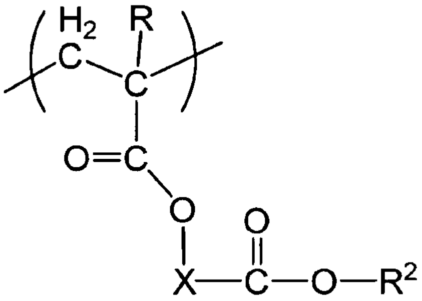

( f 1 - 1)

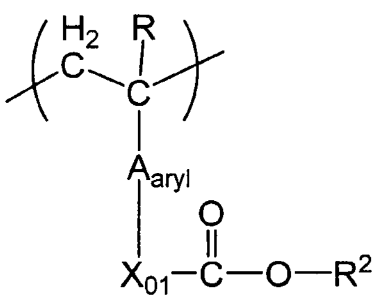

( f 1 - 2)

[In Formulae (f1-1) and (f1-2), R's are each independently a hydrogen atom, an alkyl group having 1 to 5 carbon atoms, or a halogenated alkyl group having 1 to 5 carbon atoms, X is a divalent linking group not having an acid-dissociable site, $A_{aryl}$ is a divalent aromatic cyclic group which may have a substituent, $X_{01}$ is a single bond or a divalent linking group, and $R^2$'s are each independently an organic group having a fluorine atom.]

Examples of a coating, a coating solution, and a coating composition include the following.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula $R_zSnO_{(2-(z/2)-(x/2))}(OH)_x$ (here, $0 < z \leq 2$ and $0 < (z + x) \leq 4$), the formula $R'_nSnX_{4-n}$ (here, n = 1 or 2), or a mixture thereof, wherein R and R' independently represent a hydrocarbyl group having 1 to 31 carbon atoms and X represents a ligand having a hydrolysable bond to Sn or a combination of such ligands; and a hydrolysable metal compound represented by the formula $MX'_v$ (here, M represents a metal selected from groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula $RSnO_{(3/2-x/2)}(OH)_x$ (wherein $0 < x < 3$) wherein the solution contains about 0.0025 M to about 1.5 M tin, R represents an alkyl group or a cycloalkyl group having 3 to 31 carbon atoms, and the alkyl group or the cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) irradiation or extreme ultraviolet ray (EUV: 13.5 nm) irradiation, and more preferably applied for extreme ultraviolet ray (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali such as sodium hydroxide, potassium hydroxide, sodium carbonate, sodium silicate, sodium metasilicate, or ammonia water, a primary amine such as ethylamine or n-propylamine, a secondary amine such as diethylamine or di-n-butylamine, a tertiary amine such as triethylamine or methyldiethylamine, an alcoholamine such as dimethylethanolamine or triethanolamine, a quaternary ammonium salt such as tetramethylammonium hydroxide, tetraethylammonium hydroxide, or choline, or a cyclic amine such as pyrrole or piperidine can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Further, a surfactant or the like can also be added to these developers. It is also possible to use a method in which development is performed

with an organic solvent such as butyl acetate in place of the alkaline developer and a portion where the alkali dissolution rate of the photoresist is not improved is developed.

Subsequently, the resist underlayer film is etched using the formed resist pattern as a mask. The etching may be dry etching or wet etching, and dry etching is preferable.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

Examples

Next, the contents of the present invention will be specifically described with reference to examples, but the present invention is not limited thereto.

The weight average molecular weights of the polymers shown in the following Synthesis Examples 1 to 7 and Comparative Synthesis Examples 1 to 3 in the present description are the measurement results by gel permeation chromatography (hereinafter, abbreviated as GPC). In the measurement, a GPC apparatus manufactured by Tosoh Corporation was used, and measurement conditions and the like are as follows:

· GPC column: TSKgel Super-Multipore HZ-N (two columns)
· Column temperature: 40°C
· Solvent: tetrahydrofuran (THF)
· Flow rate: 0.35 ml/min
· Standard sample: polystyrene (manufactured by Tosoh Corporation)

<Synthesis Example 1>

Under nitrogen, 15.00 g of 2,2'-biphenol (manufactured by Tokyo Chemical Industry Co., Ltd.), 8.55 g of 1-benzaldehyde (manufactured by Tokyo Chemical Industry Co., Ltd.), and 0.77 g of methanesulfonic acid (manufactured by Tokyo Chemical Industry Co., Ltd.) were added in a reaction vessel, and 24.32 g of propylene glycol monomethyl ether acetate was further charged thereinto, the reaction vessel was substituted with nitrogen, and the components were reacted together at 140°C for three hours. A reaction product was naturally cooled and then reprecipitated in methanol, an obtained precipitate was filtered and dried with a vacuum dryer at 60°C for 12 hours, thereby obtaining an intended polymer 1. As a result of GPC analysis, the obtained polymer 1 had a weight average molecular weight of 4,600 in terms of standard polystyrene and a dispersity of 2.3. The structure present in the polymer 1 is represented by the following formula.

[Chem. 52]

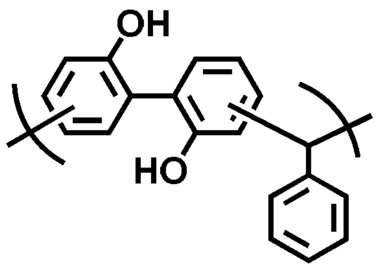

<Synthesis Example 2>

Under nitrogen, 15.00 g of 2,2'-biphenol (manufactured by Tokyo Chemical Industry Co., Ltd.), 12.58 g of 1-naphthaldehyde (manufactured by Sigma-Aldrich Co. LLC.), and 1.94 g of methanesulfonic acid (manufactured by Tokyo Chemical Industry Co., Ltd.) were added in a reaction vessel, and 29.52 g of propylene glycol monomethyl ether acetate was further charged thereinto, the reaction vessel was substituted with nitrogen, and the components were reacted together at 140°C for three hours. A reaction product was naturally cooled and then reprecipitated in methanol, an obtained precipitate was filtered and dried with a vacuum dryer at 60°C for 12 hours, thereby obtaining an intended polymer 2. As a result of GPC analysis, the polymer 2 obtained had a weight average molecular weight of 51,500 in terms of standard polystyrene and a dispersity of 29.6. The structure present in the polymer 2 is represented by the following formula.

[Chem. 53]

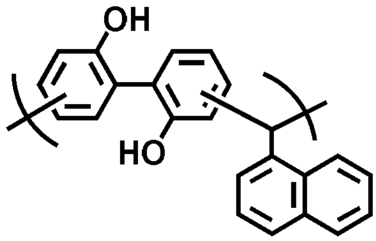

<Synthesis Example 3>

Under nitrogen, 25.00 g of 2,2'-biphenol (manufactured by Tokyo Chemical Industry Co., Ltd.), 10.48 g of 1-naphthaldehyde (manufactured by Sigma-Aldrich Co. LLC.), 15.46 g of 1-pyrenecarboxaldehyde (manufactured by Tokyo Chemical Industry Co., Ltd.), and 3.87 g of methanesulfonic acid (manufactured by Tokyo Chemical Industry Co., Ltd.) were added in a reaction vessel, and 54.81 g of propylene glycol monomethyl ether was further charged thereinto, the reaction vessel was substituted with nitrogen, and the components were reacted together at 120°C for 24 hours. A reaction product was naturally cooled and then reprecipitated in methanol, an obtained precipitate was filtered and dried with a vacuum dryer at 50°C for 10 hours, thereby obtaining an intended polymer 3. As a result of GPC analysis, the polymer 3 obtained had a weight average molecular weight of 5,000 in terms of standard polystyrene and a dispersity of 4.8. The structure present in the polymer 3 is represented by the following formula.

[Chem. 54]

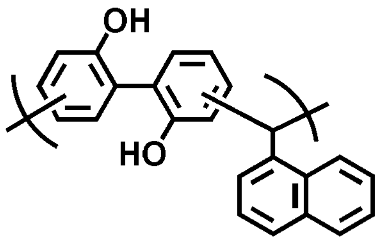

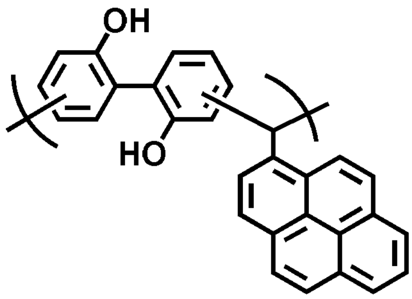

<Synthesis Example 4>

4.00 g of 1,3,5-tris(2,3-epoxypropyl) isocyanurate (product name: TEPIC-SS, manufactured by Nissan Chemical Corporation), 8.19 g of 3,7-dihydroxy-2-naphthoic acid (manufactured by Midori Kagaku Co., Ltd.), and 0.36 g of ethyltriphenylphosphonium bromide (manufactured by Hokko Chemical Industry Co., Ltd.) were added to and dissolved in 29.29 g of propylene glycol monomethyl ether in a reaction vessel. The reaction vessel was substituted with nitrogen, and then, a reaction was allowed to proceed at 140°C for 24 hours to obtain a solution containing a polymer 4. As a result of GPC analysis, the polymer 4 obtained had a weight average molecular weight of 1,000 in terms of standard polystyrene and a dispersity of 4.8. The structure present in the polymer 4 is represented by the following formula.

[Chem. 55]

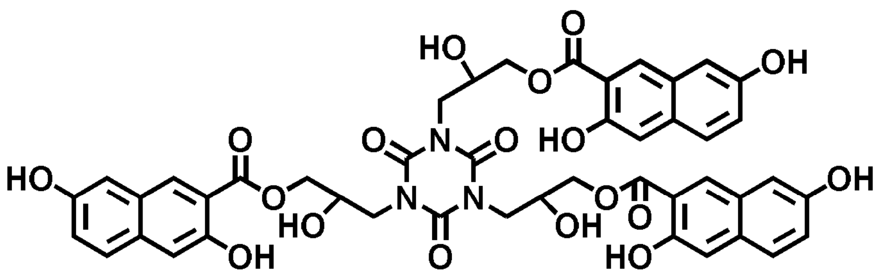

<Synthesis Example 5>

Under nitrogen, 6.00 g of (anhydrous) phloroglucin (manufactured by Tokyo Chemical Industry Co., Ltd.), 17.15 g of 4-tert-butoxystyrene (manufactured by Tokyo Chemical Industry Co., Ltd.), and 2.74 g of methanesulfonic acid (manufactured by Tokyo Chemical Industry Co., Ltd.) were added in a reaction vessel, and 23.15 g of propylene glycol monomethyl ether was further charged thereinto, and the components were reacted together at 140°C for 24 hours. A reaction product was naturally cooled and then reprecipitated in heptane, an obtained precipitate was filtered and dried with a vacuum dryer at 60°C for 12 hours, thereby obtaining an intended polymer 5. As a result of GPC analysis, the polymer 5 obtained had a weight average molecular weight of 1,300 in terms of standard polystyrene and a dispersity of 1.6. The structure present in the polymer 5 is represented by the following formula.

[Chem. 56]

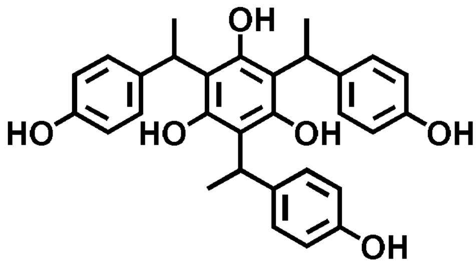

<Synthesis Example 6>

Under nitrogen, 6.00 g of (anhydrous) phloroglucin (manufactured by Tokyo Chemical Industry Co., Ltd.), 32.30 g of 2-tert-butoxy-6-vinylnaphthalene (product name:, manufactured by Tosoh Corporation), and 6.86 g of methanesulfonic acid (manufactured by Tokyo Chemical Industry Co., Ltd.) were added in a reaction vessel, and 38.30 g of propylene glycol monomethyl ether was further charged thereinto, and the components were reacted together at 140°C for 24 hours. A reaction product was naturally cooled and then reprecipitated in hexane, an obtained precipitate was filtered and dried with a vacuum dryer at 60°C for 12 hours, thereby obtaining an intended polymer 6. As a result of GPC analysis, the polymer 6 obtained had a weight average molecular weight of 970 in terms of standard polystyrene and a dispersity of 1.7. The structure present in the polymer 6 is represented by the following formula.

[Chem. 57]

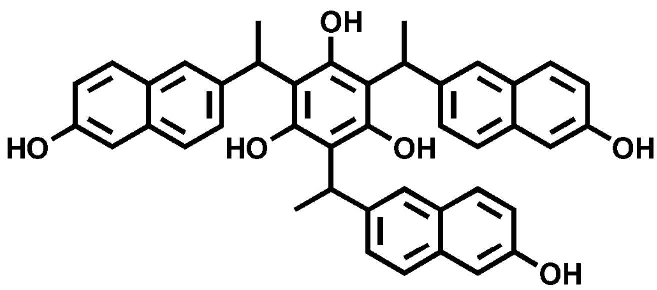

<Synthesis Example 7>

8.00 g of 2-tert-butoxy-6-vinylnaphthalene (product name:, manufactured by Tosoh Corporation) and 0.48 g of azobisisobutyronitrile (manufactured by Tokyo Chemical Industry Co., Ltd.) were dissolved in 19.79 g of propylene glycol monomethyl ether acetate (hereinafter abbreviated as PGMEA in the present specification), then, added into 14.13 g of PGMEA in a reaction vessel heated and held at 140°C, and reacted together for three hours, thereby obtaining a polymer solution. The polymer solution was naturally cooled and then reprecipitated in ultrapure water/methanol, an obtained precipitate was filtered and dried with a vacuum dryer at 60°C for 12 hours, thereby obtaining a polymer. Furthermore, 38.51 g of propylene glycol monomethyl ether acetate and 2.22 g of methanesulfonic acid (manufactured by Tokyo Chemical Industry Co., Ltd.) were added to 7.41 g of the obtained polymer, and the components were reacted together at 80°C for seven hours. A reaction product was naturally cooled and then reprecipitated in ultrapure water/methanol, an

obtained precipitate was filtered and dried with a vacuum dryer at 40°C for 24 hours, thereby obtaining an intended polymer 7. As a result of GPC analysis, the obtained polymer 7 had a weight average molecular weight of 8,300 in terms of standard polystyrene and a dispersity of 2.3. The structure present in the polymer 7 is represented by the following formula.

[Chem. 58]

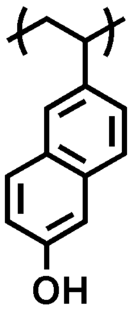

<Comparative Synthesis Example 1>

100.00 g of monoallyl diglycidyl isocyanurate (manufactured by Shikoku Chemicals Corporation), 66.4 g of 5,5-diethylbarbituric acid, and 4.1 g of benzyltriethylammonium chloride were added to and dissolved in 682.00 g of propylene glycol monomethyl ether in a reaction vessel. The reaction vessel was substituted with nitrogen, and the components were then reacted together at 130°C for 24 hours to obtain a solution containing a comparative polymer 1. As a result of GPC analysis, the obtained comparative polymer 1 had a weight average molecular weight of 6,800 in terms of standard polystyrene, and a dispersity of 4.8. The structure present in the comparative polymer 1 is represented by the following formula.

[Chem. 59]

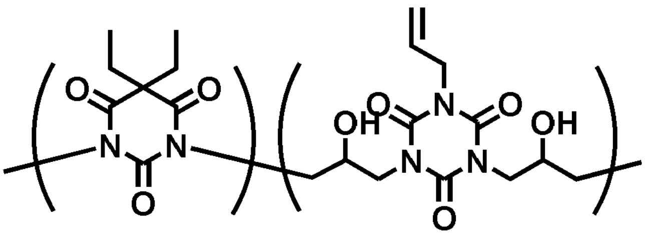

<Comparative Synthesis Example 2>

6.00 g of styrene (manufactured by Tokyo Chemical Industry Co., Ltd.), 2.50 g of 2-hydroxyethyl methacrylate (manufactured by Tokyo Chemical Industry Co., Ltd.), and 0.43 g of azobisisobutyronitrile (manufactured by Tokyo Chemical Industry Co., Ltd.) were dissolved in 20.82 g of PGMEA, then, added into 14.87 g of PGMEA in a reaction vessel heated and held at 140°C, and reacted together for 24 hours, thereby obtaining a solution containing a comparative polymer 2. As a result of GPC analysis, the obtained comparative polymer 2 had a weight average molecular weight of 7,700 in terms of standard polystyrene, and a dispersity of 2.6. The structure present in the comparative polymer 2 is represented by the following formula.

[Chem. 60]

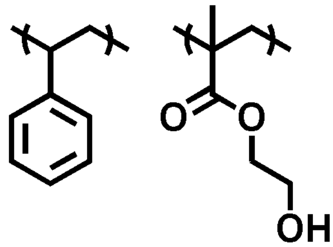

<Comparative Synthesis Example 3>

5.00 g of 4-hydroxyphenyl methacrylate (manufactured by Tokyo Chemical Industry Co., Ltd.), and 0.38 g of azobisisobutyronitrile (manufactured by Tokyo Chemical Industry Co., Ltd.) were dissolved in 20.82 g of PGMEA, then, added into 12.54 g of PGMEA in a reaction vessel heated and held at 80°C, and reacted together for 24 hours, thereby obtaining a solution containing a comparative polymer 3. As a result of GPC analysis, the obtained comparative polymer 3 had a weight average molecular weight of 3,900 in terms of standard polystyrene, and a dispersity of 1.8. The structure present in the comparative polymer 3 is represented by the following formula.

[Chem. 61]

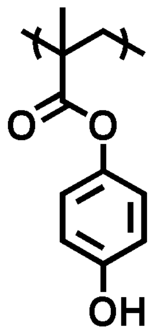

(Examples and Comparative Examples)

The compound or polymer obtained in each of Synthesis Examples 1 to 7 and Comparative Synthesis Examples 1 to 3, one of the following polymers, a crosslinking agent, a curing catalyst, and a solvent were mixed in fractions shown in Table 1-1 or Table 1-2, and the mixture was filtered with a 0.1 μm fluororesin filter to prepare a resist underlayer film-forming composition.

The following polymers were used as the polymers. Abbreviations in Table 1-1 and Table 1-2 will be also shown.

· PSF-2808: Cresol novolac resin (product name: PSF-2808, manufactured by Gun Ei Chemical Industry Co., Ltd.)
· TA: Tannic acid (product name: TANNIC ACID AL, manufactured by Fuji Chemical Industry Co., Ltd.)
· TEP-TPA: Polyphenol resin-1 (product name: TEP-TPA, manufactured by Honshu Chemical Industry Co., Ltd.)
· NF7177C: Polyphenol resin-2 (product name: NeoFARIT 7177C, manufactured by MITSUBISHI GAS CHEMICAL COMPANY, INC.)
· NFV002-EA2: Polyphenol resin-3 (product name: NeoFARIT V002-EA2, manufactured by MITSUBISHI GAS CHEMICAL COMPANY, INC.)
· NFV003: Polyphenol resin-4 (product name: NeoFARIT V003, manufactured by MITSUBISHI GAS CHEMICAL COMPANY, INC.)
· VP-8000: Phenolic resin (product name: VP-8000, manufactured by Nippon Soda Co., Ltd.)

Other abbreviations in Table 1-1 and Table 1-2 are as follows.

· PL-LI: Tetramethoxymethylglycoluril

· PGME-PL:Imidazo[4,5-d]imidazole-2,5(1H,3H)-dione,tetrahydro-1,3,4,6-tetrakis[(2-methoxy-1-methylethoxy)methyl]-

· TMOM-BP: 3,3',5,5'-tetrakis(methoxymethyl)-[1,1'-biphenyl]-4,4'-diol

· PyPSA: pyridinium-p-hydroxybenzenesulfonic acid

· R-30N: Surfactant

· PGMEA: Propylene glycol monomethyl ether acetate

· PGME: Propylene glycol monomethyl ether

Each addition amount was expressed in parts by mass, and the solvent was expressed in composition ratio.

[Table 1-1]

| | | Polymer | Crosslinking agent | Curing catalyst | Solvent composition | |
|---|---|---|---|---|---|---|
| Example 1 | Type | PSF-2808 | PGME-PL | PyPSA | PGME | PGMEA |
| | (Parts by mass) | 0.154 | 0.042 | 0.004 | 30 | 70 |
| Example 2 | Type | Synthesis Example 1 | PGME-PL | PyPSA | PGME | PGMEA |
| | (Parts by mass) | 0.165 | 0.046 | 0.004 | 30 | 70 |
| Example 3 | Type | Synthesis Example 2 | PGME-PL | PyPSA | PGME | PGMEA |
| | (Parts by mass) | 0.141 | 0.071 | 0.004 | 30 | 70 |
| Example 4 | Type | Synthesis Example 3 | PGME-PL | PyPSA | PGME | PGMEA |
| | (Parts by mass) | 0.131 | 0.066 | 0.003 | 30 | 70 |
| Example 5 | Type | TA | PGME-PL | PyPSA | PGME | PGMEA |
| | (Parts by mass) | 0.146 | 0.051 | 0.004 | 90 | 10 |
| Example 6 | Type | Synthesis Example 4 | PGME-PL | PyPSA | PGME | PGMEA |
| | (Parts by mass) | 0.146 | 0.040 | 0.004 | 70 | 30 |
| Example 7 | Type | TEP-TPA | TMOM-BP | PyPSA | PGME | PGMEA |
| | (Parts by mass) | 0.121 | 0.061 | 0.003 | 90 | 10 |
| Example 8 | Type | NF7177C | PGME-PL | PyPSA | PGME | PGMEA |
| | (Parts by mass) | 0.131 | 0.066 | 0.003 | 70 | 30 |
| Example 9 | Type | NFV002-EA2 | PGME-PL | PyPSA | PGME | PGMEA |
| | (Parts by mass) | 0.141 | 0.071 | 0.004 | 70 | 30 |
| Example 10 | Type | NFV003 | PGME-PL | PyPSA | PGME | PGMEA |
| | (Parts by mass) | 0.147 | 0.059 | 0.004 | 70 | 30 |
| Example 11 | Type | Synthesis Example 5 | PGME-PL | PyPSA | PGME | PGMEA |
| | (Parts by mass) | 0.135 | 0.047 | 0.003 | 70 | 30 |
| Example 12 | Type | Synthesis Example 6 | TMOM-BP | PyPSA | PGME | PGMEA |
| | (Parts by mass) | 0.126 | 0.051 | 0.003 | 90 | 10 |
| Example 13 | Type | VP-8000 | PGME-PL | PyPSA | PGME | PGMEA |
| | (Parts by mass) | 0.119 | 0.033 | 0.003 | 70 | 30 |
| Example 14 | Type | Synthesis Example 7 | PGME-PL | PyPSA | PGME | PGMEA |
| | (Parts by mass) | 0.135 | 0.037 | 0.003 | 70 | 30 |

[Table 1-2]

| | | Polymer | Crosslinking agent | Curing catalyst | Surfactant | Solvent composition | |
|---|---|---|---|---|---|---|---|
| Comparative Example 1 | Type | Comparative Synthesis Example 1 | PL-LI | PyPSA | R-30N | PGME | PGMEA |
| | (Parts by mass) | 0.149 | 0.037 | 0.003 | 0.001 | 70 | 30 |
| Comparative Example 2 | Type | Comparative Synthesis Example 2 | PGME-PL | PyPSA | - | PGME | PGMEA |
| | (Parts by mass) | 0.154 | 0.042 | 0.004 | - | 30 | 70 |
| Comparative Example 3 | Type | VP-8000 | PGME-PL | PyPSA | - | PGME | PGMEA |
| | (Parts by mass) | 0.103 | 0.085 | 0.003 | - | 70 | 30 |
| Comparative Example 4 | Type | Comparative Synthesis Example 3 | PGME-PL | PyPSA | - | PGME | PGMEA |
| | (Parts by mass) | 0.138 | 0.038 | 0.004 | - | 70 | 30 |

(Elution test in photoresist solvent)

Each of the resist underlayer film-forming compositions of Example 1 to Example 14 and Comparative Example 1 to Comparative Example 4 was applied onto a silicon wafer using a spinner. The silicon wafer was baked at 205°C for 60 seconds on a hot plate to obtain a film having a film thickness of 5 nm. These resist underlayer films were immersed in a mixed solution of propylene glycol monomethyl ether/propylene glycol monomethyl ether acetate = 70/30 (mass ratio), which is a solvent used for the photoresist, and a case where the film thickness change was 5 Å or less was evaluated as "good", and a case where the film thickness change was more than 5 Å was evaluated as "poor", and the results are shown in Table 2.

[Table 2]

| | Elution test |
|---|---|
| Example 1 | Good |
| Example 2 | Good |
| Example 3 | Good |
| Example 4 | Good |
| Example 5 | Good |
| Example 6 | Good |
| Example 7 | Good |
| Example 8 | Good |
| Example 9 | Good |
| Example 10 | Good |
| Example 11 | Good |

(continued)

| | Elution test |
|---|---|
| Example 12 | Good |
| Example 13 | Good |
| Example 14 | Good |
| Comparative Example 1 | Good |
| Comparative Example 2 | Good |
| Comparative Example 3 | Good |
| Comparative Example 4 | Good |

(Measurement of atomic percentage (atom%) of oxygen in phenolic hydroxy group in resist underlayer film)

Each of the resist underlayer film-forming compositions was applied onto a silicon wafer using the spinner. The silicon wafer was baked at 205°C for 60 seconds on a hot plate to obtain a resist underlayer film having a film thickness of 5 nm. The silicon wafer on which the resist underlayer film has been formed was cut into a size of about 0.5 × 1 cm and dried in a vacuum for 20 hours or longer. After that, the silicon wafer was sealed in a 6.0 × 7.5 cm weighing bottle together with 3 ml of trifluoroacetic anhydride, and a hydrogen atom in the phenolic hydroxy group was substituted with a trifluoroacetyl group by a gas phase chemical modification method at a temperature of 25°C. Regarding the reaction time, a time required to reach the reaction equilibrium was confirmed, and the reaction time was set thereto for each composition. Furthermore, unreacted trifluoroacetic anhydride and trifluoroacetic acid generated as a by-product were removed by 20 hours or longer of vacuum drying. After that, the number of each atom constituting the film was measured using X-ray photoelectron spectroscopy (Quanterar SXM) in which an AlKa ray was used as a radiation source (excluding hydrogen). In addition, the atomic percentage ($R_{OH}$ [atom%]) of oxygen in the phenolic hydroxy group in the resist underlayer film was obtained using the following formula. The atomic percentages of oxygen in the phenolic hydroxy groups in the resist underlayer films of Examples 1 to 5 and 7 to 14 and Comparative Examples 1 to 4 are shown in Table 4. Examples 1 to 5 and 7 to 14 were compared with Comparative Examples 1 to 4, and it was confirmed that the atomic percentages of oxygen in the phenolic hydroxy groups in the resist underlayer films were large.

[Math. 3]

$$R_{\mathrm{OH}}[atom\%] = \frac{F}{A} \times \frac{1}{3} \times 100$$

F: Number of fluorine atoms
A: Total number of atoms (hydrogen atoms are excluded)

[Table 3]

| | Atomic percentage of oxygen in phenolic hydroxy group (atom%) |
|---|---|
| Example 1 | 9.85 |
| Example 2 | 5.65 |
| Example 3 | 3.76 |
| Example 4 | 3.76 |
| Example 5 | 7.06 |
| Example 7 | 6.94 |
| Example 8 | 4.18 |
| Example 9 | 4.76 |

(continued)

| | Atomic percentage of oxygen in phenolic hydroxy group (atom%) |
|---|---|
| Example 10 | 4.27 |
| Example 11 | 9.01 |
| Example 12 | 3.55 |
| Example 13 | 10.50 |
| Example 14 | 4.32 |
| Comparative Example 1 | 0.00 |
| Comparative Example 2 | 0.00 |
| Comparative Example 3 | 1.37 |
| Comparative Example 4 | 1.60 |

(Evaluation of resist patterning)

[Test of resist pattern formation by electron beam lithography system]

Each of the resist underlayer film-forming compositions of Example 1 to Example 14 and Comparative Example 1 to Comparative Example 4 was applied onto a silicon wafer using the spinner. The silicon wafer was baked at 205°C for 60 seconds on a hot plate to obtain a resist underlayer film having a film thickness of 5 nm. A positive resist solution for EUV was applied onto the resist underlayer film by spin coating, followed by heating to 130°C for 60 seconds to form an EUV resist film. The resist films were exposed under the predetermined conditions using an electron beam lithography system (ELS-G130). After the exposure, the silicon wafer was baked (PEB) at 100°C for 60 seconds, cooled on a cooling plate to room temperature, and subjected to puddle developing for 30 seconds using a 2.38% aqueous tetramethylammonium hydroxide solution (trade name NMD-3 manufactured by Tokyo Ohka Kogyo Co., Ltd.) as a photoresist developer. A resist pattern having a hole size of 16 nm to 26 nm was formed. A scanning electron microscope (CG4100 manufactured by Hitachi High-Technologies Corporation) was used to measure the length of the resist pattern.

With respect to the photoresist pattern thus obtained, whether or not a contact hole (C/H) of 23 nm could be formed was checked. In all cases of Examples 1 to 14, 23 nm C/H pattern formation was confirmed. In addition, the charge amount at which the 23 nm contact hole was formed was defined as the optimum irradiation energy, and irradiation energies ($\mu C/cm^2$) for which that in Comparative Example 1 was regarded as 1.00 are shown in Table 4. In Examples 1 to 14, reductions in the optimum irradiation energy as compared with Comparative Examples 1 to 4 were confirmed.

[Table 4]

| | Irradiation energy ($uC/cm^2$) |
|---|---|
| Example 1 | 0.95 |
| Example 2 | 0.91 |
| Example 3 | 0.93 |
| Example 4 | 0.96 |
| Example 5 | 0.93 |
| Example 6 | 0.97 |
| Example 7 | 0.96 |
| Example 8 | 0.86 |
| Example 9 | 0.92 |
| Example 10 | 0.87 |
| Example 11 | 0.89 |
| Example 12 | 0.96 |
| Example 13 | 0.86 |

(continued)

| | Irradiation energy (uC/cm$^2$) |
|---|---|
| Example 14 | 0.95 |
| Comparative Example 1 | 1.00 |
| Comparative Example 2 | 1.02 |
| Comparative Example 3 | 0.98 |
| Comparative Example 4 | 1.01 |

Industrial Applicability

The resist underlayer film-forming composition according to the present invention is capable of providing a resist underlayer film-forming composition for forming a resist underlayer film on which a desired resist pattern can be formed, a method for producing a resist patterned substrate and a method for producing a semiconductor device, in both of which the resist underlayer film-forming composition is used.

## Claims

**1.** A resist underlayer film-forming composition, comprising:

a compound (A) containing an aromatic hydrocarbon ring to which a phenolic hydroxy group is bonded; and
a solvent (B),
wherein an atomic percentage of oxygen in the phenolic hydroxy group in a cured film of the composition is 2.00% or more.

**2.** The resist underlayer film-forming composition according to claim 1, wherein the compound (A) contains at least any one of a phenolic resin, a naphthol resin, a biphenol resin, polyhydroxystyrenes, and polyhydroxyvinylnaphthalenes.

**3.** The resist underlayer film-forming composition according to claim 1, wherein the compound (A) is a low molecular compound (A-1) containing two or more phenolic hydroxy groups and having a molecular weight of 5,000 or less.

**4.** The resist underlayer film-forming composition according to claim 1, further comprising a crosslinking agent (C).

**5.** The resist underlayer film-forming composition according to claim 1, which is a resist underlayer film-forming composition for EUV or electron beam lithography.

**6.** A resist underlayer film, which is a cured product of the resist underlayer film-forming composition according to any one of claims 1 to 5.

**7.** The resist underlayer film according to claim 6, wherein the atomic percentage of oxygen in the phenolic hydroxy group is 2.00% or more in the resist underlayer film.

**8.** The resist underlayer film according to claim 6, wherein a film thickness is 2 nm or more and 20 nm or less.

**9.** A laminate, comprising:

a semiconductor substrate; and
the resist underlayer film according to claim 6.

**10.** A method for producing a semiconductor element, the method comprising the steps of:

forming a resist underlayer film on a semiconductor substrate using the resist underlayer film-forming composition according to any one of claims 1 to 5; and
forming a resist film on the resist underlayer film.

**11.** A pattern forming method, comprising the steps of:

forming a resist underlayer film on a semiconductor substrate using the resist underlayer film-forming composition according to any one of claims 1 to 5;
forming a resist film on the resist underlayer film;
irradiating the resist film with light or an electron beam, and then developing the resist film to obtain a resist pattern; and
etching the resist underlayer film using the resist pattern as a mask.

**INTERNATIONAL SEARCH REPORT**

International application No.
**PCT/JP2024/013182**

**A. CLASSIFICATION OF SUBJECT MATTER**

***G03F 7/11***(2006.01)i; ***C08G 8/04***(2006.01)i
FI: G03F7/11 503; C08G8/04

According to International Patent Classification (IPC) or to both national classification and IPC

**B. FIELDS SEARCHED**

Minimum documentation searched (classification system followed by classification symbols)

G03F7/11; C08G8/04

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2020/026879 A1 (MITSUBISHI GAS CHEMICAL COMPANY, INC.) 06 February 2020 (2020-02-06)<br>claims, paragraph [0102], examples 16, 38 | 1-11 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 June 2024** | **18 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/013182**

| Patent document cited in search report | Publication date (day/month/year) | Patent family member(s) | Publication date (day/month/year) |
|---|---|---|---|
| WO 2020/026879 A1 | 06 February 2020 | US 2021/0294214 A1<br>claims, paragraph [0142], examples 16, 38<br>EP 3832390 A1<br>CN 112513737 A<br>KR 10-2021-0036873 A<br>TW 202016651 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2006003850 A
- JP 2005526270 A
- WO 2020111068 A
- WO 2019188595 A
- WO 2019187881 A
- WO 2019187803 A
- WO 2019167737 A
- WO 2019167725 A
- WO 2019187445 A
- WO 2019167419 A
- WO 2019123842 A
- WO 2019054282 A
- WO 2019058945 A
- WO 2019058890 A
- WO 2019039290 A
- WO 2019044259 A
- WO 2019044231 A
- WO 2019026549 A
- WO 2018193954 A
- WO 2019172054 A
- WO 2019021975 A
- WO 2018230334 A
- WO 2018194123 A
- JP 2018180525 A
- WO 2018190088 A
- JP 2018070596 A
- JP 2018028090 A
- JP 2016153409 A
- JP 2016130240 A
- JP 2016108325 A
- JP 2016047920 A
- JP 2016035570 A
- JP 2016035567 A
- JP 2016035565 A
- JP 2019 A
- JP 101417 A
- JP 2019117373 A
- JP 2019052294 A
- JP 2019008280 A
- JP 2019008279 A
- JP 2019003176 A
- JP 2019003175 A
- JP 2018197853 A
- JP 2019191298 A
- JP 2019061217 A
- JP 2018045152 A
- JP 2018022039 A
- JP 2016090441 A
- JP 2015010878 A
- JP 2012168279 A
- JP 2012022261 A
- JP 2012022258 A
- JP 2011043749 A
- JP 2010181857 A
- JP 2010128369 A
- WO 2018031896 A
- JP 2019113855 A
- WO 2017156388 A
- WO 2017066319 A
- JP 2018041099 A
- WO 2016065120 A
- WO 2015026482 A
- JP 2016029498 A
- JP 2011253185 A

### Non-patent literature cited in the description

- *Proc. SPIE*, 2000, vol. 3999, 330-334
- *Proc. SPIE*, 2000, vol. 3999, 357-364
- *Proc. SPIE*, 2000, vol. 3999, 365-374